# EUROPEAN PATENT APPLICATION

(11) **EP 3 656 536 A1**
(43) Date of publication of application: **27.05.2020**
(21) Application number: 19210109.5
(22) Date of filing: 19.11.2019
(51) Int. Cl.: B29C 64/106, B29C 64/393, B33Y 50/02, H04N 1/387, H04N 1/409

(54) **FABRICATING SYSTEM, INFORMATION PROCESSING APPARATUS, AND METHOD FOR EXPRESSING SHAPE OF FABRICATION OBJECT**

(30) Priority: 21.11.2018 JP 2018218496; 27.02.2019 JP 2019033567; 27.09.2019 JP 2019176956
(71) Applicant: Ricoh Company, Ltd., Tokyo 143-8555 (JP)
(72) Inventor: YOROZU, Yasuaki, Tokyo, 143-8555 (JP)
(74) Representative: SSM Sandmair

(57) **Abstract**

A fabricating system (1000) for three-dimensional fabrication includes an acquiring unit (340), a measuring unit (340), a setting unit (351), and a calculation unit (352). The acquiring unit (340) is configured to acquire a reference shape. The measuring unit (340) is configured to measure a shape of a fabrication object during or after fabrication, to acquire a measured shape of the fabrication object. The setting unit (351) is configured to set a plurality of representative points of the reference shape based on the reference shape. The calculation unit (352) is configured to, based on the measured shape of the fabrication object by the measuring unit (340), calculate difference data representing a difference between the reference shape and the measured shape of the fabrication object as a deformation represented by displacements of the plurality of representative points.

## Description

### BACKGROUND

### Technical Field

The present disclosure relates to a fabricating system, an information processing apparatus, and a method for expressing a shape of a fabrication object.

### Related Art

There has been developed a technology called fabricating apparatus (so-called "3D printer") or additive manufacturing that forms a three-dimensional fabrication object of resin or metal without preparing a mold based on input data. As the method of performing three-dimensional fabrication, there have been proposed, for example, fused filament fabrication (FFF), selective laser sintering (SLS), material jetting (MJ), electron beam melting (EBM), and stereo lithography apparatus (SLA).

However, conventionally, the accuracy of the shape of the fabrication object is low. Even if the same material are fabricated in the same shape under the same conditions, the shape of the fabrication object obtained may vary due to, for example, distortion, and the stable fabricating quality may not be obtained, which is not sufficient.

For example, JP-2016-215641-A is known as a technique for correcting fabrication process. In JP-2016-215641-A, calibration markers made of a fabrication material are formed by an image forming unit, the calibration markers stacked on a stage is detected by a sensor. Image distortion of a previous calibration marker stacked on the stage is detected from the detection result. For the technique of JP-2016-215641-A, when a fabrication object is formed, based on the image distortion measured in advance, correction for reducing the image distortion is performed on sliced image data to be given to the image forming unit.

The technique of JP-2016-215641-A aims to improve the quality and accuracy of a fabrication object and can detect an error and correct the shape to some extent. On the other hand, there are various factors that deteriorate the fabricating accuracy, such as mechanical and optical factors of the fabricating apparatus, the shrinkage and deformation of material, and deformation due to fluidity of the material before the material is solidified. The technique of JP-2016-215641-A enables calibration and registration that corrects a fabrication shape and alignment at the time of stacking caused by mechanical and optical error factors of the fabricating apparatus. However, the technique cannot cope with shrinkage and deformation of the material, deformation due to fluidity of the material before solidification of the material, etc. From such a point, the technique is not sufficient. In addition, since a calibration marker having a specific shape is used, it is difficult to improve the fabricating accuracy of a complicated shape. Even if the technique can cope with the complicated shape, the calculation load for estimation increases and the accuracy is not sufficient.

### SUMMARY

The present disclosure has been made in view of the above-mentioned point and a purpose of the present disclosure is to provide a fabricating system that can enhance the accuracy and stability of a three-dimensional shape of a fabrication object with low calculation load.

In an aspect of the present disclosure, there is provided a fabricating system for three-dimensional fabrication that includes an acquiring unit, a measuring unit, a setting unit, and a calculation unit. The acquiring unit is configured to acquire a reference shape. The measuring unit is configured to measure a shape of a fabrication object during or after fabrication, to acquire a measured shape of the fabrication object. The setting unit is configured to set a plurality of representative points of the reference shape based on the reference shape. The calculation unit is configured to, based on the measured shape of the fabrication object by the measuring unit, calculate difference data representing a difference between the reference shape and the measured shape of the fabrication object as a deformation represented by displacements of the plurality of representative points.

In another aspect of the present disclosure, there is provided an information processing apparatus that includes a first acquiring unit, a second acquiring unit, a setting unit, and a calculation unit. The first acquiring unit is configured to acquire a reference shape. The second acquiring unit is configured to acquire a shape of a fabrication object during or after fabrication. The setting unit is configured to set a plurality of representative points of the reference shape based on the reference shape. The calculation unit is configured to, based on the shape of the fabrication object acquired by the second acquiring unit, calculate difference data representing a difference between the reference shape and the shape of the fabrication object acquired by the second acquiring unit, as a deformation represented by displacements of the plurality of representative points.

In still another aspect of the present disclosure, there is provided a method for expressing a shape of a fabrication object with a computer. The method includes acquiring a reference shape; acquiring a measured shape of a fabrication object during or after fabrication; setting a plurality of representative points of the reference shape based on the reference shape; and calculating, based on the reference shape acquired and the measured shape acquired, difference data representing a difference between the reference shape and the measured shape of the fabrication object, as a deformation represented by displacements of the plurality of representative points.

The above-described configurations can enhance the accuracy and stability of the three-dimensional shape of a fabrication object with a low calculation load.

### BRIEF DESCRIPTION OF THE DRAWINGS

A more complete appreciation of the disclosure and many of the attendant advantages and features thereof can be readily obtained and understood from the following detailed description with reference to the accompanying drawings, wherein:
FIGS. 1A to 1C are illustrations of a schematic configuration of an entire three-dimensional fabricating system according to an embodiment of the present disclosure;
FIG. 2 is a diagram of a hardware configuration of a fabricating apparatus according to the embodiment illustrated in FIGS. 1A to 1C;
FIG. 3 is a block diagram of software included in the fabricating apparatus according to the embodiment illustrated in FIGS. 1A to 1C;
FIG. 4A is a graph of height map information as measurement data; FIG. 4B is a graph of polygon data representing a measurement shape of a fabrication object; FIG. 4C is an illustration of difference data in an initial state (before optimization) for generating measured shape data in the embodiment illustrated in FIGS. 1A to 1C; FIG. 4D is an illustration of a data structure of the measured shape data (difference data) as an optimal solution representing the measured shape of the fabrication object;
FIGS. 5A and 5B are illustrations of data structures of difference data in an initial state (before optimization) for generating measured shape data according to another embodiment;
FIG. 6 is a flowchart of a process for generating measured shape data (difference data) in the embodiment illustrated in FIGS. 1A to 1C;
FIG. 7 is a graph plotting experimental results of examples of measured shape data (difference data) acquired at a plurality of points in time in a specific embodiment of the present disclosure;
FIGS. 8A to 8C are illustrations of a process of holding a correction result of a specific shape and correcting in advance (a process of feedforward correction with measured shape data) in a specific embodiment of the present disclosure;
FIGS. 9A to 9E are illustrations of an example in which the shape of a fabrication object is deformed and feedback correction for the example;
FIG. 10 is a diagram of a data flow in the embodiment illustrated in FIGS. 1A to 1C;
FIGS. 11A to 11C are illustrations of a process of tracking deformation of the shape of a fabrication layer in layered (lamination) fabrication in a specific embodiment;
FIG. 12 includes graphs in which, regarding five points on an upper side of a three-dimensional fabrication object, the amounts of deformations of the corresponding points of each layer corresponding to the five points are plotted assuming that the three-dimensional fabrication object is a three-dimensional fabrication object illustrated in FIG. 11C (FIG. 12 compares a case with correction (at the upper graph) and a case without correction (at the lower graph);
FIG. 13 is a flowchart of a process in which the fabricating apparatus fabricates a three-dimensional fabrication object in the embodiment illustrated in FIGS. 1A to 1C;
FIGS. 14A to 14G are illustrations of deformation of the shape of the fabrication object and feedforward correction on the shape in the embodiment illustrated in FIGS. 1A to 1C;
FIG. 15 is a flowchart of dummy fabrication in the embodiment illustrated in FIGS. 1A to 1C;
FIG. 16 is a flowchart of main fabrication the embodiment illustrated in FIGS. 1A to 1C;
FIGS. 17A to 17D are illustrations of an edge detected with a shape sensor;
FIGS. 18A to 18C are illustrations of examples of a fabrication layer corrected based on the edge detected with the shape sensor;
FIGS. 19A and 19B are illustrations of correction of measurement data based on offset values in the embodiment illustrated in FIGS. 1A to 1C;
FIGS. 20A to 20D are illustrations of examples of the shape of a dummy fabrication object for calculating offset values in the embodiment illustrated in FIGS. 1A to 1C;
FIG. 21 is a flowchart of a process of calculating an offset value in the embodiment illustrated in FIGS. 1A to 1C; and
FIGS. 22A and 22B are illustrations of an example in which an offset value is calculated during the main fabrication.
FIG. 23 is a block diagram of software included in a fabricating apparatus according to another embodiment of the present disclosure;
FIG. 24 is an illustration of measurement of the shape of a fabrication object performed by dividing a measurement range in a fabricating apparatus according to another embodiment of the present disclosure; and
FIGS. 25A to 25F are illustrations of a fabrication process for calculating a correction amount of a discharge amount based on difference data and performing fabrication based on the correction amount in a specific embodiment.

The accompanying drawings are intended to depict embodiments of the present invention and should not be interpreted to limit the scope thereof. The accompanying drawings are not to be considered as drawn to scale unless explicitly noted.

### DETAILED DESCRIPTION

The terminology used herein is for the purpose of describing particular embodiments only and is not intended to be limiting of the present invention. As used herein, the singular forms "a", "an" and "the" are intended to include the plural forms as well, unless the context clearly indicates otherwise.

In describing embodiments illustrated in the drawings, specific terminology is employed for the sake of clarity. However, the disclosure of this specification is not intended to be limited to the specific terminology so selected and it is to be understood that each specific element includes all technical equivalents that have a similar function, operate in a similar manner, and achieve a similar result.

Hereinafter, although embodiments of the present disclosure are described with specific embodiments, embodiments of the present disclosure are not limited to the embodiments described below. In the drawings referred below, the same signs are used for the common elements, and the description thereof will be omitted as appropriate. The following descriptions are given of mainly a fabricating apparatus of a fused filament fabrication (FFF) system. However, embodiments of the present disclosure are not limited to the fabricating apparatus of the FFF system.

In the following description, the height direction of a three-dimensional fabrication object is referred to as z-axis direction, and a plane orthogonal to the z-axis direction is referred to as xy plane for convenience of explanation.

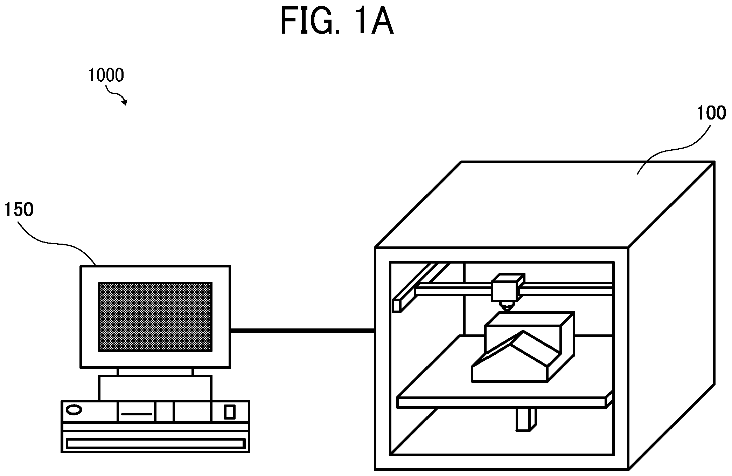

FIGS. 1A to 1C are illustrations of a schematic configuration of an entire three-dimensional fabricating system according to an embodiment of the present disclosure. As illustrated in FIG. 1A, a three-dimensional fabricating system 1000 according to the present embodiment includes a fabricating apparatus 100 that fabricates a three-dimensional fabrication object. The fabricating apparatus 100 receives the shape data of a three-dimensional fabrication object to be fabricated from, for example, an information processing terminal 150 and fabricates the three-dimensional fabrication object based on the shape data. The information processing terminal 150 may operate as a controller that controls a process executed by the fabricating apparatus 100. The fabricating apparatus 100 may incorporate a function of the information processing terminal 150.

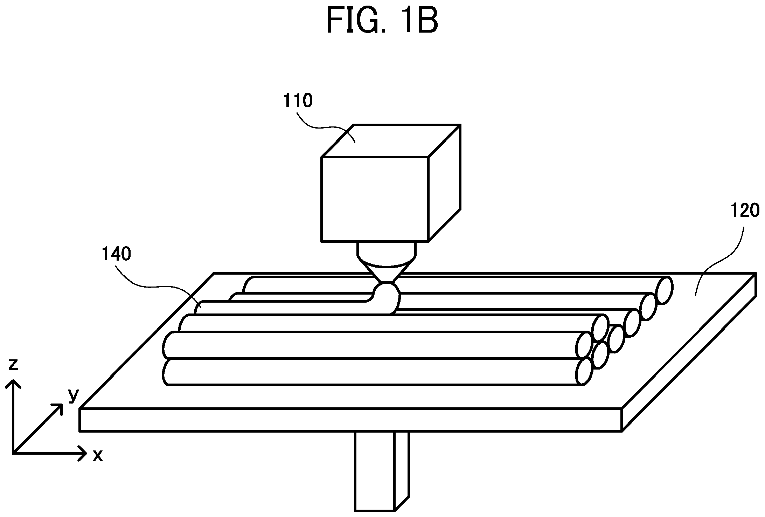

As illustrated in FIG. 1B, a fabrication material 140 is discharged onto a stage 120 from a head 110 that is movable in parallel with the xy plane, and a fabrication layer is fabricated on the xy plane. The fabricating apparatus 100 performs line drawing in the same plane to fabricate a fabrication layer corresponding to one layer of a three-dimensional fabrication object. When the first fabrication layer is fabricated, the stage 120 is lowered by the height (layer pitch) of one layer in a direction along the z axis. Then, the fabricating apparatus 100 drives the head 110 in the same manner as for the first fabrication layer to form a second fabrication layer. The fabricating apparatus 100 repeats the above-described operation to laminate fabrication layers and fabricate the three-dimensional fabrication object. In the above description, the fabricating apparatus 100 is described with an example of the configuration of moving the head 110 in the xy plane and moving the stage 120 in the z-axis direction. However, the configuration of the fabricating apparatus 100 is not limited to the above-described configuration in the present embodiment but may be any other suitable configuration.

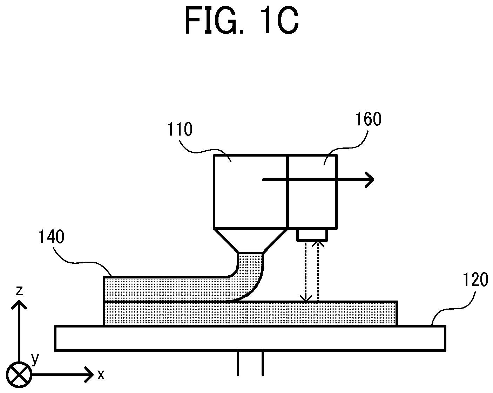

The fabricating apparatus 100 according to the present embodiment includes a sensor 160 to measure the shape of a fabrication layer during fabrication or the shape of a three-dimensional fabrication object after fabrication. The sensor 160 may measure the xy plane of the fabrication layer. As illustrated in FIG. 1C, in a preferred embodiment, the sensor 160 may measure the shape of the fabrication layer during fabrication, for example, in conjunction with the fabricating operation by the head 110. The three-dimensional fabrication object may also be measured each time one fabrication layer is fabricated. Further, the timing and range of the measurement of the three-dimensional fabrication object may be arbitrarily selected and are not particularly limited to the above-described embodiment.

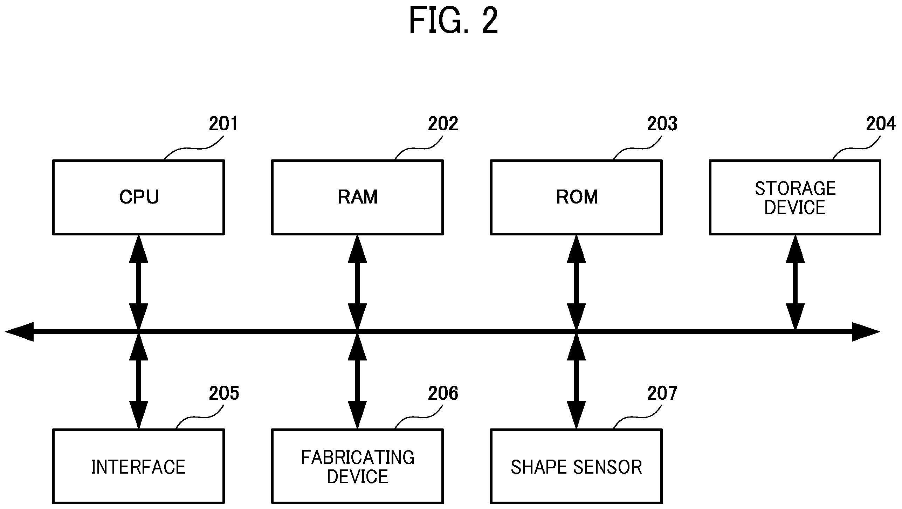

Next, a hardware configuration of the fabricating apparatus 100 is described below. FIG. 2 is a diagram of a hardware configuration of the fabricating apparatus 100 according to the present embodiment. As illustrated in FIG. 2, the fabricating apparatus 100 includes a central processing unit (CPU) 201, a random access memory (RAM) 202, a read only memory (ROM) 203, a storage device 204, an interface 205, a fabricating device 206, and a shape sensor 207. Such hardware components are connected via a bus.

The CPU 201 is a device that executes programs to control operations of the fabricating apparatus 100 and performs predetermined processing. The RAM 202 is a volatile storage device to provide an execution space of programs executed by the CPU 201 and is used to store and expand programs and data. The ROM 203 is a nonvolatile storage device to store programs and firmware, etc., executed by the CPU 201.

The storage device 204 is a readable and writable non-volatile storage device that stores an operation system (OS), various applications, programs, setting information, various data, and the like that cause the fabricating apparatus 100 to function. The interface 205 is a device to connect the fabricating apparatus 100 to another apparatus. The interface 205 can be connected to, for example, the information processing terminal 150, a network, and an external storage device. The fabricating apparatus 100 can receive control data of fabricating operation, shape data of three-dimensional fabrication objects, and the like via the interface 205.

The fabricating device 206 is a device that fabricates a fabrication layer based on fabrication data as fabricator. The fabricating device 206 includes the head 110, the stage 120, and the like, and is configured in accordance with a fabrication method. For example, the fabricating device 206 of an FFF system includes a heating mechanism to melt the fabrication material 140, a nozzle to discharge the fabrication material 140, and so on. The fabricating device 206 of a selective laser sintering (SLS) method includes a laser light source and the like.

The shape sensor 207 is a device that measures the shape of the fabrication layer during fabrication or the three-dimensional fabrication object after fabrication. The shape sensor 207 may measure the xy plane of the fabrication layer. The shape sensor 207 may measure, for example, the dimensions in the x-axis, y-axis, and z-axis directions of a three-dimensional fabrication object. Examples of the shape sensor 207 include an infrared sensor, a camera, and a three-dimensional measurement sensor (for example, a light-cutting profile sensor).

In the above description, the hardware configuration of the fabricating apparatus 100 is described with reference to FIG. 2. Although the information processing terminal 150 may not include the fabricating device 206 and the shape sensor 207, the information processing terminal 150 can also employ a generally similar hardware configuration.

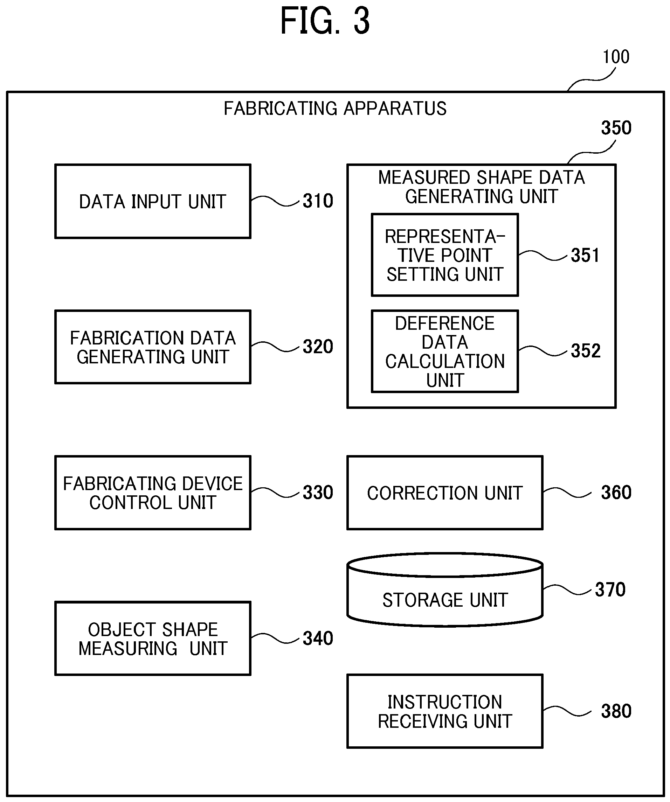

Next, functions implemented by each hardware of the present embodiment are described with reference to FIG. 3. FIG. 3 is a block diagram of software included in the fabricating apparatus 100 according to the present embodiment.

As illustrated in FIG. 3, the fabricating apparatus 100 includes a data input unit 310, a fabrication data generating unit 320, a fabricating-device control unit 330, an object shape measuring unit 340, a measured shape data generating unit 350, a correction unit 360, and a storage unit 370.

The data input unit 310 receives input such as shape data to form a three-dimensional fabrication object. The shape data is generated by, for example, the information processing terminal 150 and is input to the data input unit 310 via the interface 205. The input shape data can be used to generate a shape that serves as a reference when generating measured shape data described later.

The fabrication data generating unit 320 is a generating unit that divide a three-dimensional shape, which is defined by the shape data input to the data input unit 310, with respect to the height direction into cross-sectional shapes to generate fabrication data of a plurality of fabrication layers. The three-dimensional fabrication object to be fabricated is divided in unit of lamination pitch, and the fabrication date is generated as data indicating the shape of a fabrication layer to form each layer to be laminated. Fabrication data can be expressed as vector data consisting of vertex coordinates and line segments connecting the vertex coordinates and can also be expressed as raster data consisting of binary data indicating whether to fabricate in the xy plane coordinates of each layer. In some embodiments, not only the presence or absence of fabrication at each coordinate but also the amount of fabrication at each coordinate, the discharge amount of the fabrication material, and the like may be included as parameters. The fabrication data may also include information that defines a tool path that defines a movement path of a tool. The fabrication data can be used to generate a reference shape used when generating measured shape data described later. In FIG. 3, the fabrication data generating unit 320 is included in the fabricating apparatus 100. In some embodiments, the fabrication data generating unit 320 may be included in the information processing terminal 150. In such a case, the fabrication data generated by the information processing terminal 150 is transmitted to the fabricating apparatus 100 to execute the fabricating process.

The fabricating-device control unit 330 controls an operation of fabricating a three-dimensional fabrication object with the fabricating device 206 according to the fabrication data. The fabricating-device control unit 330 adjusts the position of the head 110 and the height of the stage 120 according to the fabrication data so that the fabricating-device control unit 330 can fabricate the three-dimensional fabrication object while controlling various parameters, such as the fabrication speed and the lamination pitch, and algorithms. The fabricating-device control unit 330 can also control the fabrication amount according to the fabrication data. For example, the discharge amount of the fabrication material 140 can be controlled in the FFF method, and the laser intensity can be controlled in the SLS method.

The object shape measuring unit 340 as a measuring unit controls the shape sensor 207 and measures measurement data, such as dimensions and height, as the shape of a fabrication layer (fabrication object in the middle of fabrication) during fabrication or a three-dimensional fabrication object after fabrication. The object shape measuring unit 340 acquires the measurement results as measurement data.

The timing for measuring the shape of the fabrication object with the shape sensor 207 is not limited to any particular timing but may be, for example, certain time points in fabrication (for example, when each layer is formed) or certain time points after fabrication (for example, when a sufficient time has passed after fabrication or time points at certain intervals). The measurement data is expressed as a three-dimensional shape or a cross-sectional shape. When the fabrication object is measured as a three-dimensional shape, the shape of an object having been fabricated can be measured at a desired time point during and after fabrication. On the other hand, when fabrication object is measured as a cross-sectional shape, typically, the shape of the xy plane of the uppermost layer at the time of measurement is measured. Alternatively, the cross-sectional shape measured at a desired time point may be obtained by measuring a three-dimensional shape at the desired time point and cutting out from the measured three-dimensional shape at a desired cross-section. The object shape measuring unit 340 constitutes a measuring unit that measures the shape of a fabrication object during fabrication or after fabrication in the present embodiment.

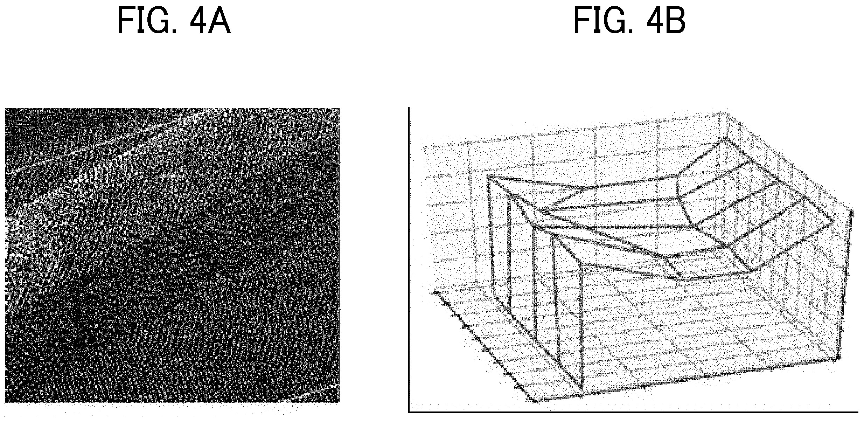

FIG. 4A depicts a data example of height map information as measurement data. The measurement data acquired by the object shape measuring unit 340 may be height map information including z-direction coordinates (heights) of points arranged at equal intervals on the xy plane in a lattice shape as illustrated in FIG. 4A.

The shape of the three-dimensional fabrication object to be actually fabricated may vary depending on the type of the fabrication material 140 and various conditions such as ambient temperature. After the fabrication material 140 is cooled or hardened, shrinkage or warpage may be more likely to than immediately after fabrication. Continuing the lamination of layers with shrinkage and the like may cause fabrication of a three-dimensional fabrication object different from the desired three-dimensional fabrication object. Therefore, it is preferable to compare the desired shape with the actually fabricated shape, detect errors, modify and re-fabricate the entire three-dimensional shape, or feed back the errors to and correct the fabrication of the next and subsequent layers.

The height map information described above can be used for shape comparison. However, if the height map information is used as it is, the data size is large, which requires time for various processes and causes a large calculation load for shape comparison. Furthermore, the height map information includes measurement noise. For this reason, it may be not realistic to use the height map information as it is. FIG. 4B illustrates polygon set data representing the measured shape of the fabrication object. As illustrated in FIG. 4B, the height map information illustrated in FIG. 4A can also be expressed as a set of surfaces of polygons by merging a plurality of points, which are adjacent to each other on the same plane, into a surface of a polygon and converting the three-dimensional fabrication object into the surfaces of the polygons. However, it may be difficult to generate polygon data by the expression format illustrated in FIG. 4B by extracting the size and shape of the fabrication object with high accuracy while removing measurement noise.

Therefore, the measured shape data generating unit 350 according to the present embodiment generates measured shape data in an expression format differing from the measurement data, based on the measurement data and the shape data that defines the three-dimensional shape (or fabrication data that defines the cross-sectional shape generated from the three-dimensional shape). Here, the measured shape data is data representing the measured shape as minute displacements from the reference shape. The measured shape data can be expressed as a three-dimensional shape or a cross-sectional shape of the xy plane, an xz plane, or a yz plane. Based on the reference shape (three-dimensional shape or cross-sectional shape), the measured shape (three-dimensional shape or cross-sectional shape) is expressed by assuming that the shape has slightly been deformed from the reference shape, thus balancing noise reduction and highly-accurate shape extraction. For the above-described purpose, the measured shape data generating unit 350 includes, for example, a representative point setting unit 351 and a difference data calculation unit 352.

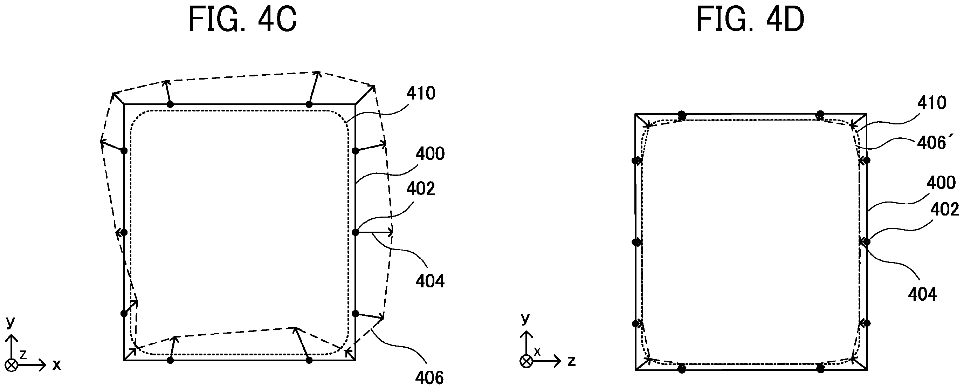

The representative point setting unit 351 is a setting unit that sets a plurality of representative points representing the shape based on the reference shape. FIG. 4C and FIG. 4D illustrate examples of the data structure of difference data in an initial state for generating measured shape data according to the present embodiment and the data structure of difference data as an optimal solution, respectively. FIG. 4C illustrates the initial state given at random. However, the initial state may be zero or an optimal solution one layer before. FIG. 4C and FIG. 4D also illustrate representative points 402 set to a reference shape 400. FIGS. 4C and 4D correspond to the case where measured shape data is generated as the cross-sectional shape of the xy plane. Therefore, the representative points are set on the xy plane.

FIG. 4C depicts the cross-sectional shape (reference shape) 400 of the fabrication object in the xy plane based on the input shape data and representative points 402 set to (the contour of) the cross-sectional shape 400 in the xy plane. The representative point setting unit 351 can preferably set a plurality of representative points 402 with a relatively low density in a portion where the reference shape 400 gently changes and with higher density in a portion where the shape sharply changes. The plurality of representative points 402 may be set, for example, at a portion such as a corner (for example, a vertex of the corner) where the shape significantly changes and a position adjacent to the portion (for example, a position away from the vertex of the corner by a certain distance). The representative points 402 may be further set at predetermined intervals in a straight portion or a curved portion of the shape.

Based on the measurement data representing the measured shape, the difference data calculation unit 352 calculates the difference between the reference shape 400 and the measured shape of the fabrication object as a deformation expressed by the displacement of the set representative points.

When the measured shape data is generated as the cross-sectional shape of the fabrication object in the xy plane as illustrated in FIG.4C and FIG.4D, difference data is calculated that represents the difference between the reference cross-sectional shape 400 of the fabrication object in the xy plane and the measured cross-sectional shape of the fabrication object in the xy plane. The measurement data is given as a cross-sectional shape obtained by cutting out the shape in the xy plane of the uppermost layer at the time of measurement or the three-dimensional shape measured at the time of measurement during or after fabrication, on the corresponding xy plane. Similarly, the reference cross-sectional shape in the xy plane can be obtained by cutting out corresponding fabrication data or a three-dimensional shape defined by the shape data on the corresponding xy plane.

More specifically, the difference data calculation unit 352 applies, as an initial values, a random displacement, a zero displacement, or a displacement of the optimal solution one layer before, to each of the plurality of representative points representing the reference shape. The displacements other than the representative points are given by, for example, interpolation, thus allowing the result of minute deformation of the entire shape to be calculated. FIG. 4C depicts displacement vectors 404 representing random displacement given as the initial value and a minute deformation result 406 of the entire shape as the initial value. The difference data calculation unit 352 gradually changes and updates the positions of the representative points and displacements thereof so that the error between the shape defined by the displacement vectors of the representative points and the shape defined by the measurement data is minimized. Thus, the optimum solution of the positions of the representative points 402 and the displacement vectors 404 can be obtained. Here, the positions of the plurality of representative points themselves are also targets for updating. Alternatively, only the displacements may be targets for updating.

FIGS. 4C and 4D depicts a measured cross-sectional shape 410 defined by the measurement data. The displacement vector 404 is optimized as a vector connecting from the representative point 402 in the reference cross-sectional shape 400 to the corresponding point on the measured cross-sectional shape 410. In FIG. 4D, reference numeral 406' represents the result of minute deformation of the entire shape as the optimum solution. The obtained positions and displacements of the representative points constitute difference data between the input three-dimensional cross-sectional shape and the measured cross-sectional shape. The difference data is expressed as vector data, thus allowing highly accurate expression of the shape. For example, when measurement is performed using a scanner with a resolution of 300 dpi (corresponding to a resolution of approximately 80 µm), the difference data can be obtained with a dimensional accuracy of a fraction of the scanning pitch (an accuracy of approximately 10 µm).

The displacements are represented by a plurality of points according to the reference shape, thus allowing removal of high frequency noise. On the other hand, since the shape is expressed as displacements based on the reference shape, the fine shape is not ignored and can be distinguished. In other words, representative points are relatively sparsely set in a portion of the reference shape that has only monotonous and low spatial frequency components, to block high frequency components as noise. On the other hand, representative points are relatively densely set in another portion of the reference shape that has complex and high spatial frequency components, to maintain the high spatial frequency components. Such a configuration can balance the reproducibility of shape and the ease of noise removal.

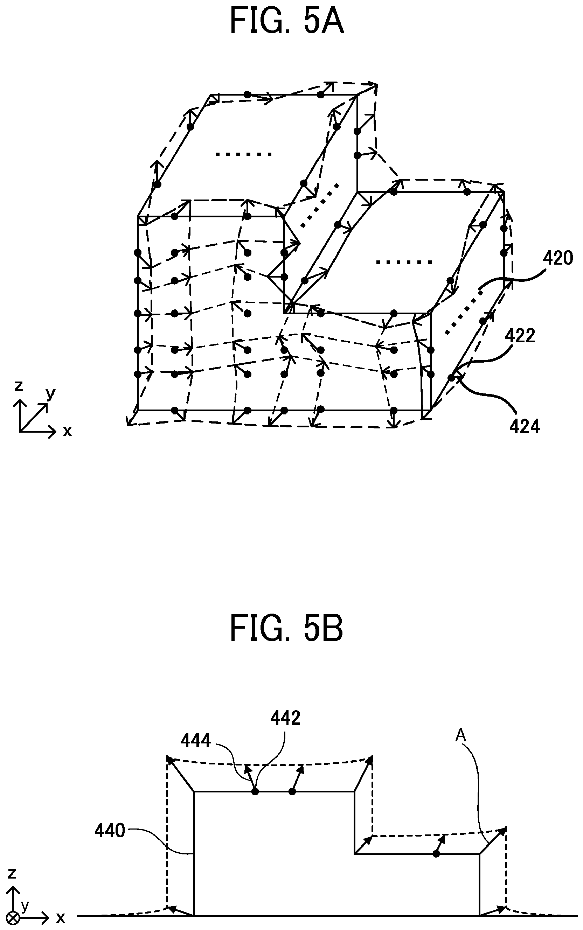

In FIGS. 4C and 4D, it is assumed that the reference shape, the measured shape, and the difference data of the measured shape data generated are all expressed as cross-sectional shape in the xy plane. However, for example, the shape may be obtained as a three-dimensional solid shape as illustrated in FIG. 5A. When the measured shape data is generated as a three-dimensional shape, according to a three-dimensional shape 420 as a reference, a plurality of representative points 422 representing the three-dimensional shape 420 are set in a three-dimensional space (a surface of the three-dimensional shape) as illustrated in FIG. 5A. Note that, in FIG. 5A, representative points are drawn in detail only on one surface of the three-dimensional shape 420 and the remaining points are simplified. An appropriate displacement 424 is given to each representative point, and an optimal solution is obtained so that an error from the measured three-dimensional shape is reduced. Difference data is calculated that represents the difference between the reference three-dimensional shape 420 and the measured three-dimensional shape of the fabrication object. The reference three-dimensional shape 420 is a shape to be fabricated at the time of measurement. If the time of measurement is after fabrication, the reference three-dimensional shape 420 is a three-dimensional shape defined by the input shape data. If the time of measurement is during fabrication, the reference three-dimensional shape 420 is the shape of a portion of the whole three-dimensional shape that is to be fabricated at that time of measurement.

Alternatively, as illustrated in FIG. 5B, the shape may be obtained as deformation of the xz plane or the yz plane. When the measured shape data is generated as the cross-sectional shape of the fabrication object in the xz plane and the yz plane including the height direction, as illustrated in FIG. 5B, a plurality of representative points 442 representing a cross-sectional shape 440 as a reference are set in a plane in the corresponding cross section. Initial displacements 444 are given to the representative points at random or based on an adjacent cross-section, and the optimum solution is obtained so that the error from the measured shape is reduced. Thus, difference data is calculated that represents a difference between the reference cross-sectional shape 440 and the measured cross-sectional shape of the fabrication object. The reference cross-sectional shape 440 is a cross-sectional shape in a three-dimensional shape to be fabricated at the time of measurement. If the time of measurement is after fabrication, the reference cross-sectional shape 440 is a cross-sectional shape in the three-dimensional shape defined by the input shape data. If the time of measurement is during fabrication, the reference cross-sectional shape 440 is a cross-sectional shape in a part of the entire three-dimensional shape that should be fabricated by the time of measurement point.

Note that the different data may be calculated by comparing the cross-sectional shapes as illustrated in FIGS. 4C, 4D, or 5B, instead of the three-dimensional shape as illustrated in FIG. 5A, thus allowing the calculation cost to be further reduced.

The correction unit 360 corrects fabrication data for fabricating a three-dimensional fabrication object. The correction unit 360 can correct the fabrication data based on the measured shape data (difference data) calculated by the measured shape data generating unit 350 so that the fabricating operation performed by the fabricating-device control unit 330 is changed. Here, changing the fabricating operation includes, for example, changing parameters or algorithms included in the fabrication data and changing the shape data itself. Examples of the parameters and algorithms include the shape of the three-dimensional fabrication object to be fabricated, the dimension and height of each fabrication layer, the fabrication amount based on the fabrication data, the melting temperature of the fabrication material, the fabrication speed, and the lamination pitch.

Three-dimensional (3D) fabrication is performed by laminating fabrication layers of cross-sectional shapes obtained by cutting a desired shape into round slices. Therefore, adjacent fabrication layers are expected to have the same shape or similar shapes. Hence, for example, the difference data (displacement vector) is calculated so that the error between a desired shape up to a fabrication layer having been completed by the time of measurement and the measured fabrication object is reduced. The fabrication data of the subsequent fabrication layer can be corrected so that the shape is distorted in the opposite direction and output. When the fabrication data is corrected, the fabricating-device control unit 330 can execute a fabricating process based on the corrected fabrication data.

Errors in the final shape of the three-dimensional fabrication object obtained are mostly due to the shape of the three-dimensional fabrication object itself. If the conditions are the same, it is expected that a similar shape part will cause the same deformation. Therefore, when a part or all of the fabrication data matches a predetermined shape registered in advance, the correction unit 360 can apply a predetermined correction to the fabrication data and output the corrected fabrication data. In such a case, one or a plurality of predetermined shapes may be prepared to obtain effective correction data for each shape in advance. When three-dimensional shapes having at least partially same shaped portions are fabricated under the same conditions, the at least partially same shaped portions can be corrected based on the accumulated correction results.

The storage unit 370 stores various data, such as shape data, fabrication data, measurement data, measured shape data (difference data) in the storage device 204. Various data are written into and read from the storage unit 370 by functional units. In addition, to apply a predetermined correction and output corrected fabrication data, the storage unit 370 can function as an accumulation unit that accumulates a correction result corrected based on the calculated difference data.

In the correction of the fabrication data, the measurement result of a shape having been completed up to a predetermined layer may be fed back to the fabrication of the subsequent fabrication layers. Alternatively, for example, to reflect the correction from the first layer, the fabricating process may be started over. For this purpose, the fabricating apparatus 100 may include an instruction receiving unit 380 that receives an instruction for applying feedback to subsequent layers or starting the fabrication over. The instruction receiving unit 380 can receive an instruction from the operator to continue the fabrication based on the corrected three-dimensional shape during fabrication or to start the fabrication over based on the corrected three-dimensional shape.

The above-described functional unit allows a three-dimensional fabrication object to be formed with high accuracy. In the embodiment illustrated in FIG. 3, it has been described that all the functional units illustrated in FIG. 3 are included in the fabricating apparatus 100. However, the configuration of the functional units is not limited to any particular configuration. For example, a part or all of the functional units may be included in the information processing terminal 150 or a part of the functional units may be included in, for example, another information processing apparatus (for example, a computer on the cloud) connected to the information processing terminal 150 via a network.

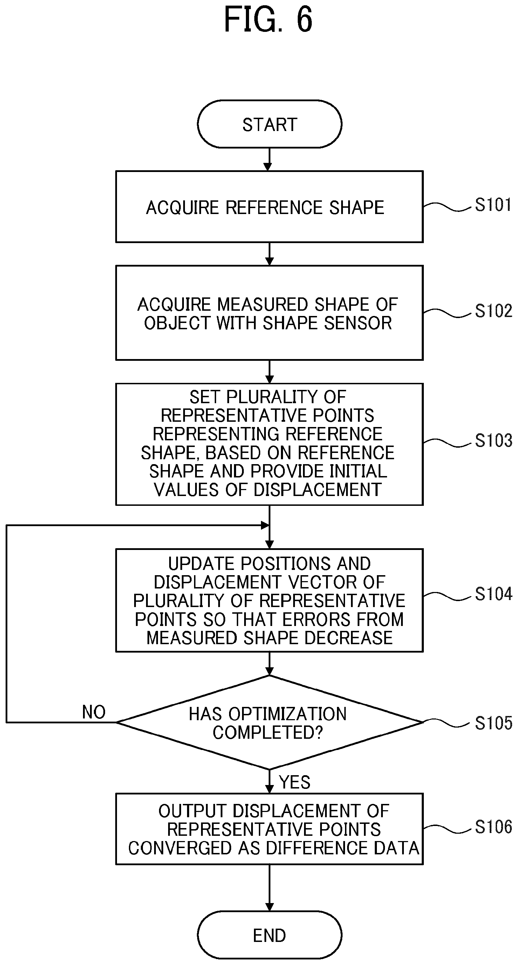

Next, a process executed by the fabricating apparatus 100 (or the information processing terminal 150) according to the present embodiment is described below. FIG. 6 is a flowchart of a process for generating measured shape data in the present embodiment. First, the fabricating apparatus 100 starts the calculation process.

In step S101, the fabricating apparatus 100 acquires a reference shape. As described above, the reference shape is (a whole or part of) a three-dimensional shape or (a whole or part of) a cross-sectional shape that is to be fabricated by the time of measurement. Examples of the three-dimensional shape and the cross-sectional shape include not only the three-dimensional shape based on the input shape data and the cross-sectional shape based on the fabrication data generated from the shape data but also a corrected three-dimensional shape obtained after the input shape data is corrected, a corrected cross-sectional shape obtained after the fabrication data generated from the input shape data is corrected, a re-corrected three-dimensional shape and cross-sectional shape obtained after the corrected three-dimensional shape and cross-sectional shape is further corrected, and a predicted three-dimensional shape and cross-sectional shape at a predetermined time predicted by simulation from a predetermined three-dimensional shape and cross-sectional shape.

In step S102, the fabricating apparatus 100 acquires, with the shape sensor 207, the measured shape of the fabrication object defined by the measurement data. As described above, the measurement data is expressed as a three-dimensional shape or a cross-sectional shape.

In step S103, based on a reference shape, the fabricating apparatus 100 sets a plurality of representative points representing the reference shape and assigns appropriate initial values of displacements. In step S104, the fabricating apparatus 100 slightly changes and updates the positions and displacements of the plurality of representative points so that an error from the measured shape is reduced.

In step S105, the fabricating apparatus 100 determines whether completion of optimization can be determined as a result of updating the positions and displacements of the plurality of representative points. Completion of optimization may be determined based on a convergence condition that, for example, the change between the previous error and the current error is less than a predetermined threshold (the error is no longer improved) or may be determined based on a censoring condition at a predetermined upper limit number of times in addition to the convergence condition.

If it is determined in step S 105 that the optimization has not yet been completed (NO), the process loops to step S104 to continue updating the positions and displacements of the plurality of representative points. alternatively, if it is determined in step S105 that the optimization has already been completed (YES), the process proceeds to step S106.

In step S106, the fabricating apparatus 100 outputs the optimized positions and displacements of the plurality of representative points as measured shape data (difference data) and ends the process. Thereafter, the three-dimensional shape is corrected based on the measured shape data.

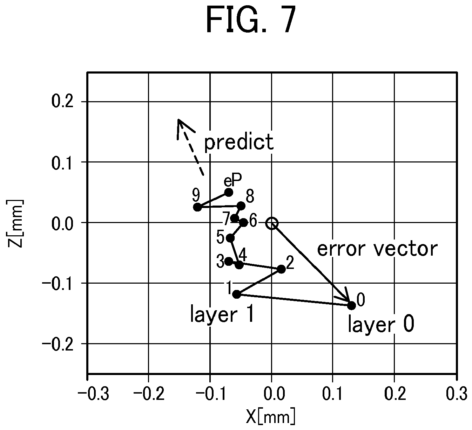

FIG. 7 is an experimental result of transition of a three-dimensional shape based on measured shape data (difference data) acquired at a plurality of points during fabrication in a specific embodiment. In FIG. 7, how the deformation of a specific point on a three-dimensional shape (for example, a representative point indicated by A in FIG. 5B) changes with the passage of time during fabrication is tranced, and the error from the target position on the xz plane is plotted and displayed as a vector. Referring to FIG. 7, how the error vector changes due to deformation caused by thermal contraction can be quantitatively observed. It becomes possible to correct fabrication based on measured shape data (difference data) calculated by performing measurement a plurality of times during such fabrication. In addition, it is possible to predict how the three-dimensional shape will be displaced thereafter and at what displacement the three-dimensional shape will eventually converge. Thus, variations in fabrication results due to variations of conditions of the fabricating process can be reduced. If the same shape is to be fabricated, it is also possible to fabricate the three-dimensional shape after correcting the three-dimensional shape in advance, assuming that the same deformation can be expected.

Hereinafter, a method for correcting the three-dimensional shape using the measured shape data obtained by the above-described process is described below.

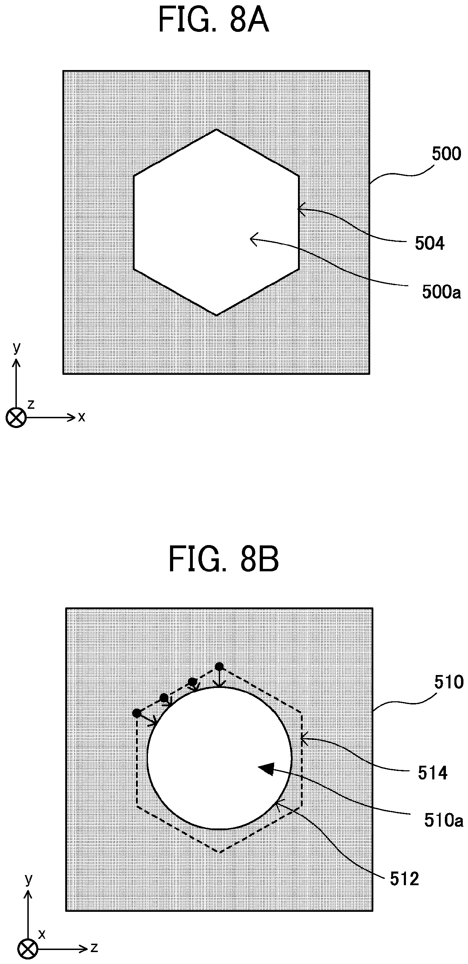

FIGS. 8A to 8C illustrate a process of holding a correction result of a specific shape and correcting in advance (a process of correcting data-dependent deformation by feedforward control) in a specific embodiment. Even if a fabricating apparatus tries to fabricate an input shape as it is, the input shape may not be fabricated as intended. One possible cause is that the material would flow and deform until the material is heated, melted, fabricated, and shaped and then cooled and solidified.

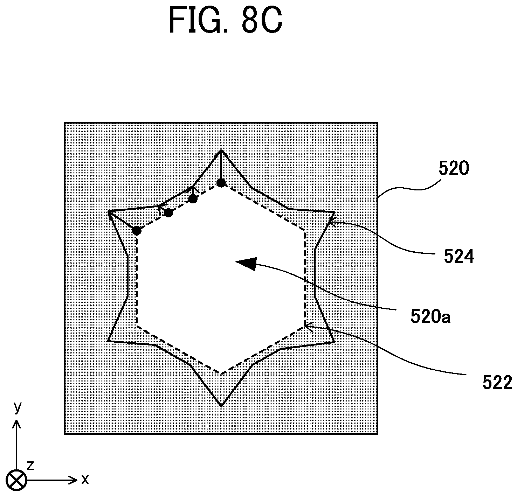

Due to such factors, for example, even if an attempt is made to form a three-dimensional fabrication object 500 having a hole 500a of a hexagonal shape 504 as illustrated in FIG. 8A, as illustrated in FIG. 8B, a hole 510a of a round shape 512 in which corners of a hexagonal shape 514 are removed and rounded would be formed. Such deformation would be generated in the same manner every time if the same material is used under the same fabrication conditions and the same shape. Hence, the object shape measurement unit 340 measures the shape, the measured shape data generating unit 350 calculates the measured shape data (difference data), and the correction unit 360 emphasizes the corners in advance as illustrated in FIG. 8C to correct the shape data to a shape 524. Based on the shape 524 corrected by the correction unit 360, a fabrication object 520 having a hole 520a of a desired hexagonal shape 522 can be fabricated.

The above-described correction is performed in the same manner every time. Therefore, if the correction is performed once, the content of the correction can be accumulated and applied when the same shape appears next time. Thus, applying the correction from the beginning allows fabrication without causing an error as much as possible. Such a configuration can reduce the fabrication error due to known deformation. Using only one correction result might cause a large error due to variations from time to time. Therefore, it is expected that the error can be further reduced by accumulating the results of fabricating the same shape repeatedly. At this time, based on the difference data between the desired three-dimensional shape and the measured shape of the fabrication object 520 obtained by fabricating the corrected three-dimensional shape, the printer characteristics (change from the hexagonal shape 514 to the shape 512 or change from the corrected shape 524 to the hexagonal shape 522) may be corrected. Furthermore, the corrected three-dimensional shape may be re-corrected, and the stored correction result may be updated. Thus, variations in fabrication results due to variations of conditions of the fabricating process can be reduced.

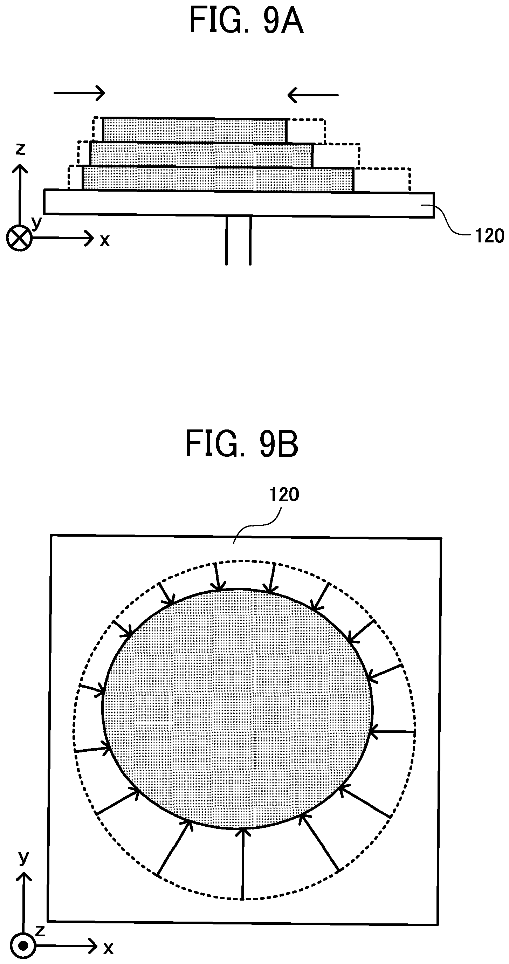

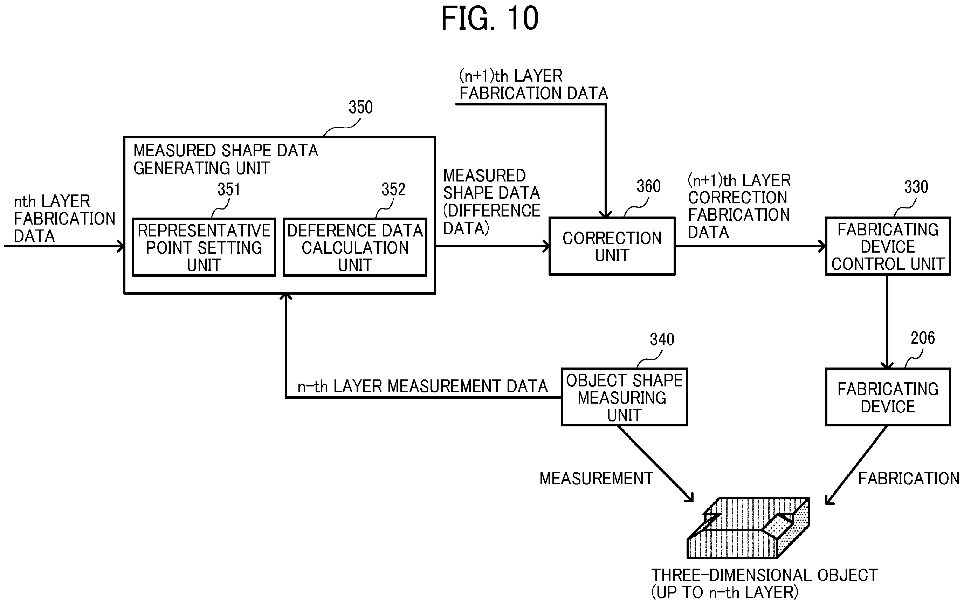

Next, a more specific example of fabricating a desired three-dimensional fabrication object in the present embodiment is described. The following description is given with reference to FIGS. 9A to 9E and FIG. 10. FIGS. 9A to 9E are illustrations of an example of deformation of the shape of a fabrication object and feedback correction for the example. FIG. 10 is a diagram of a data flow in the present embodiment.

As described above, a three-dimensional fabrication object may be fabricated in a shape different from a shape of fabrication data due to an error in the fabricating process. The three-dimensional fabrication object fabricated by the fabricating apparatus 100 undergoes thermal shrinkage or the like due to cooling over time. The shape of the three-dimensional fabrication object may change between immediately after fabrication and after cooling. For example, FIG. 9A depicts the shapes of the three-dimensional fabrication object immediately after fabrication and after cooling. A broken line indicates the shape immediately after fabrication, and a solid line indicates the shape after cooling. Since the three-dimensional fabrication object shrinks from the broken line shape to the solid line shape by cooling, the three-dimensional fabrication object is fabricated in a shape different from a desired shape. In the present embodiment, the measured shape data generating unit 350 can calculate the deformation of the plane shape due to the fabrication error or shrinkage of each layer as measured shape data (difference data) and correct the plane shape of each layer based on the calculated shape data.

As illustrated in FIG. 10, the object shape measuring unit 340 measures the shape of the nth layer of the three-dimensional fabrication object in the xy plane that has been fabricated up to the n layer, and obtains measurement data. The measured shape data generating unit 350 calculates the difference data of an actual shape from the reference shape of the nth layer, based on the fabrication data (plane shape) of the nth layer and the measurement data (plane shape) of the nth layer.

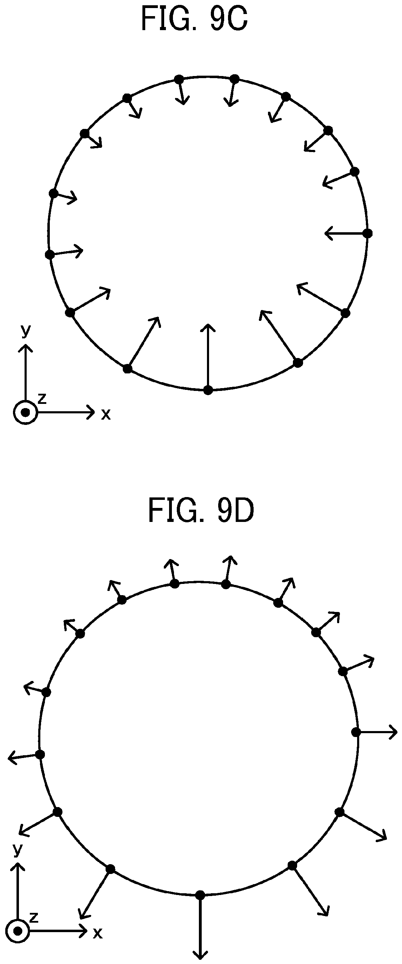

Here, an example of the error of a fabrication layer is illustrated in FIG. 9B. A broken line represents a reference plane shape based on fabrication data, and a solid line represents a measured plane shape of an actually-fabricated fabrication layer. FIG. 9C depicts measured shape data (difference data) obtained. The difference data is represented by displacement vectors from representative points of a reference plane shape as illustrated in FIG. 9C indicates the directions and amounts of displacements of edge portions of the fabricated fabrication layer.

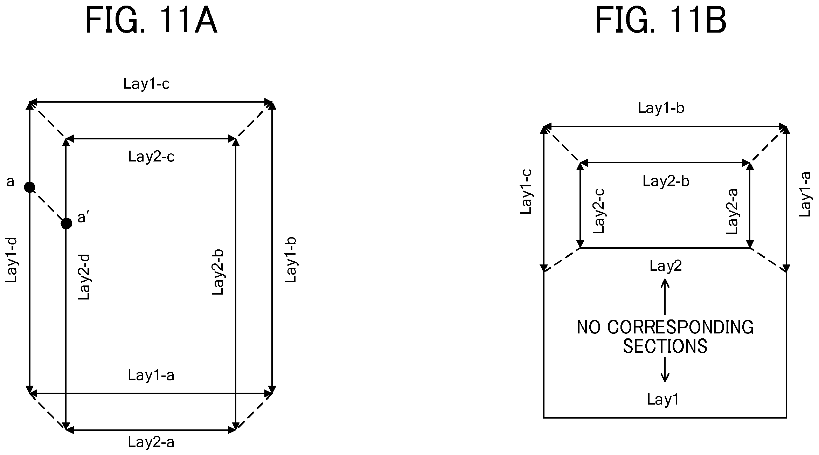

In the correction, correction vectors for correcting fabrication errors of the next layer are calculated based on the displacement vectors illustrated in FIG. 9C. For example, when the nth layer and the (n + 1)th layer have the same shape, deformation generated in the nth layer can be regarded as having a high probability to also occur at the (n + 1)th layer. Therefore, correction vectors can be calculated based on the displacement vectors of the plane shape of the nth layer. Even when the nth layer and the (n + 1)th layer have different shapes, the correction vectors can be calculated based on the displacement vectors and the relationship between section, representative point, and the corresponding point illustrated in FIGS. 11A and 11B.

FIG. 9D depicts an example of the calculated correction vectors. The correction vector is basically an inverted version of the displacement vector. The correction vector is determined to be smaller than the magnitude of the displacement vector so as not to oscillate due to excessive correction.

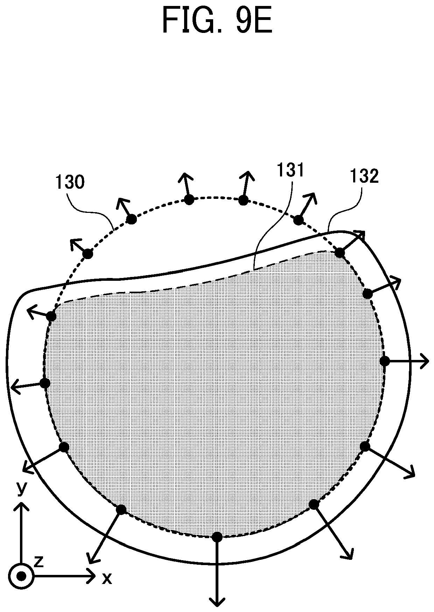

FIG. 9E depicts an example of correction when the nth layer and the (n + 1)th layer have different shapes. Assume that fabrication data (plane shape) 131 of the (n + 1)th layer is given to fabrication data (plane shape) 130 of the nth layer. At this time, as illustrated in FIG. 11A, based on the correspondence between the shapes of the nth layer and the (n + 1)th layer, errors of the nth layer are fed back to obtain correction vectors of the (n + 1)th layer, and a shape 132 is obtained.

The correction unit 360 corrects the fabrication data of the (n + 1)th layer based on the correction vectors and generates the corrected fabrication data of the (n + 1)th layer. That is, the corrected fabrication data of the (n + 1)th layer is fabrication data in which displacements due to the fabrication errors have been corrected based on the measurement results up to the nth layer. Based on the fabrication data, the fabricating-device control unit 330 controls the fabricating device 206.

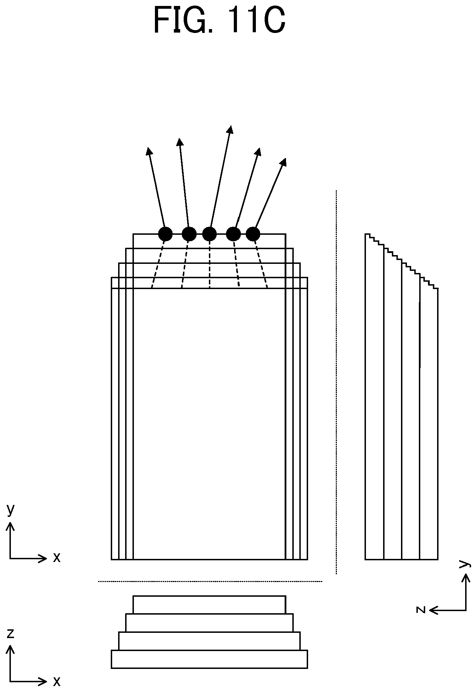

FIGS. 11A, 11B, and 11C are illustrations of a process for tracking the deformation of the shape of a fabrication layer in layered fabrication and performing feedback correction of the shape on the subsequent layers. In layered fabrication, the shape of layers to be stacked is different for each layer. However, a similar shape is expected between upper and lower adjacent layers. In the deformation phenomenon of the entire three-dimensional fabrication objection, such as warpage due to heat shrinkage, of deformations of the three-dimensional shape, the plane shapes of different layers are likely to similarly deform. Therefore, even if the shape differs slightly from layer to layer, following deformation of a lower layer allows feedback correction based on the assumption that similar deformation also occurs in fabricating an upper layer.

Hence, a corresponding section between layers is determined in advance to obtain a corresponding point a' of the upper layer corresponding to a representative point a of the lower layer. FIG. 11A and FIG. 11B are illustrations of how to determine the correspondence between layers. FIG. 11A illustrates how to determine the correspondence when the upper layer and the lower layer are similar. FIG. 11B illustrates how to determine the correspondence when the shapes of the upper layer and the lower layer are different. As illustrated in FIG. 11B, when the shape sharply changes between layers, a range having no corresponding section is also assumed. In any case, defining the corresponding section between layers determines that a point on one layer corresponds to a point on another layer. When difference data is calculated as displacement vectors of a plurality of representative points in the cross-sectional shape of the lower layer and fed back to the formation of the cross-sectional shape of the upper layer, correction can be performed assuming that the corresponding point a' is deformed by the displacement vector.

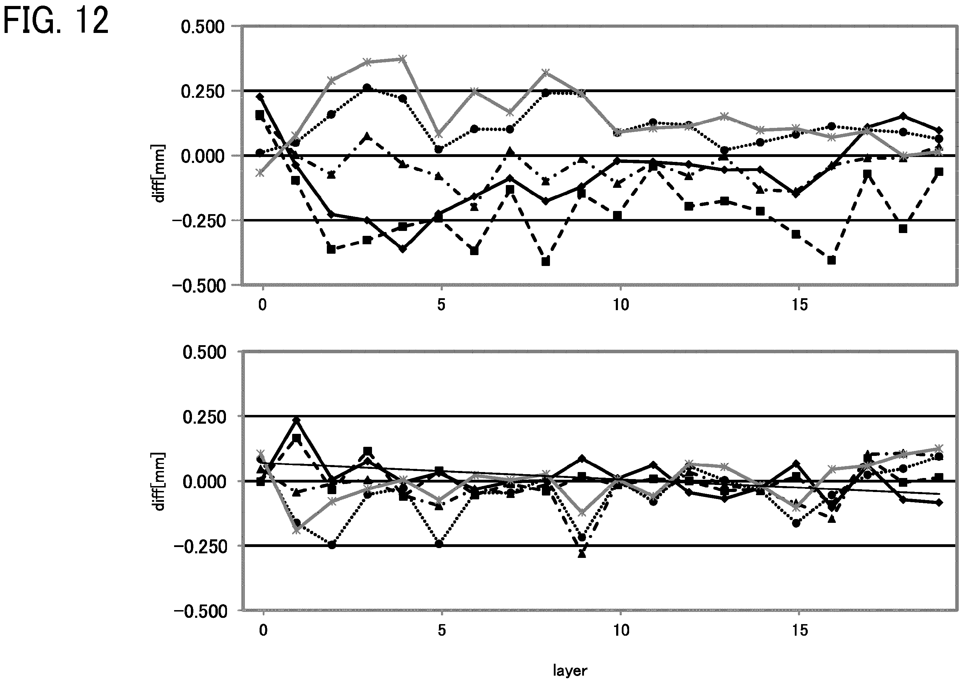

FIG. 11C is an illustration of an example of a fabrication object and a layer configuration of the fabrication object. FIG. 12 includes graphs in which how five points on the upper side are deformed each time a layer is laminated is plotted as a transition of deformation of the corresponding points, assuming that a three-dimensional fabrication object illustrated in FIG. 11C having layers differing from each other in shape and size is fabricated. In FIG. 12, the horizontal axis represents layer, and the vertical axis represents the difference (in unit of mm) obtained as measured shape data. The graph at an upper stage represents a case without correction and the graph at a lower stage represents a case with correction. According to FIG. 12, even if the shape is different for each layer, fabrication errors can be reduced by determining a corresponding section between layers and feeding back errors of corresponding points to correct the shape.

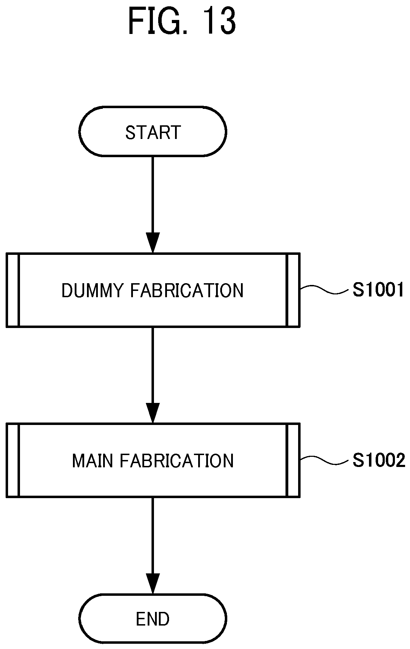

Next, a specific process executed by the fabricating apparatus of the present embodiment is described. FIG. 13 is a flowchart of a process in which the fabricating apparatus fabricates a three-dimensional fabrication object in the present embodiment.

The fabricating apparatus 100 starts the fabricating process. In step S1001, the fabricating apparatus 100 performs dummy fabrication to modify correction vectors. Note that the dummy fabrication can be omitted.

In step S1002, the fabricating apparatus 100 performs a main fabrication to fabricate a three-dimensional fabrication object having a desired shape. After performing main fabrication, the fabricating apparatus 100 ends the fabricating process.

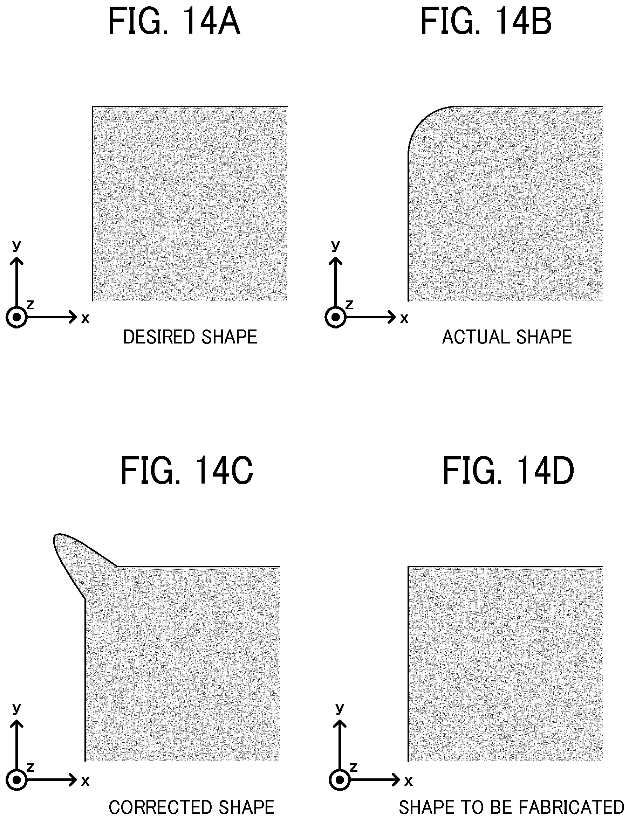

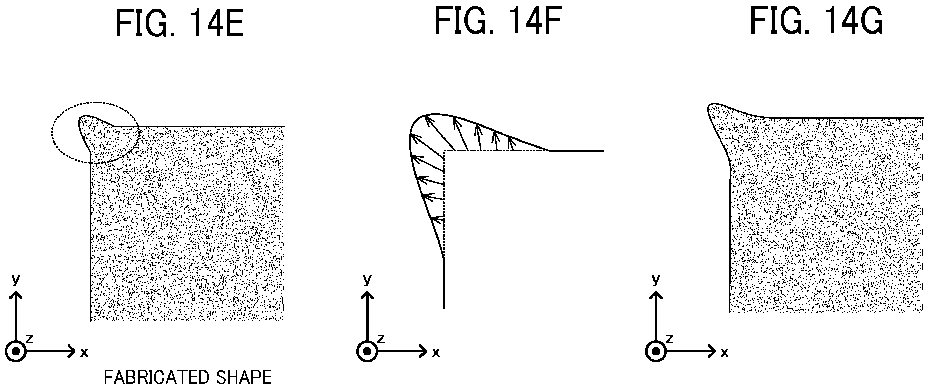

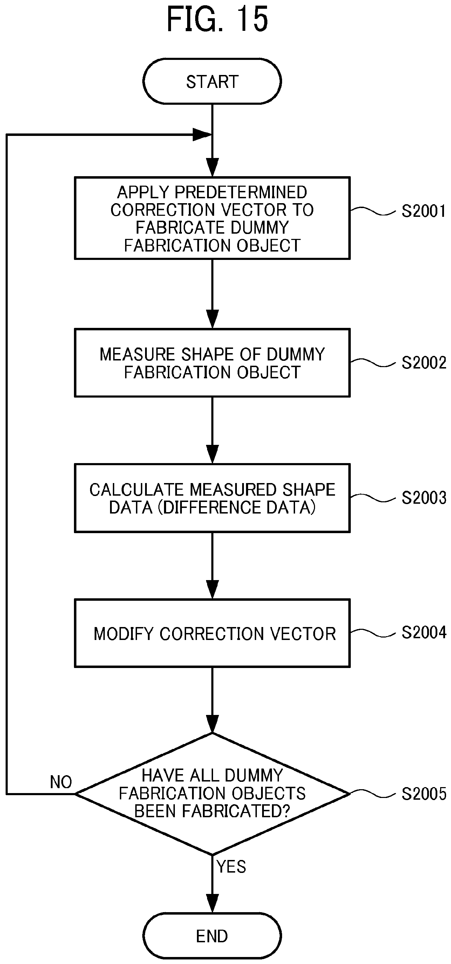

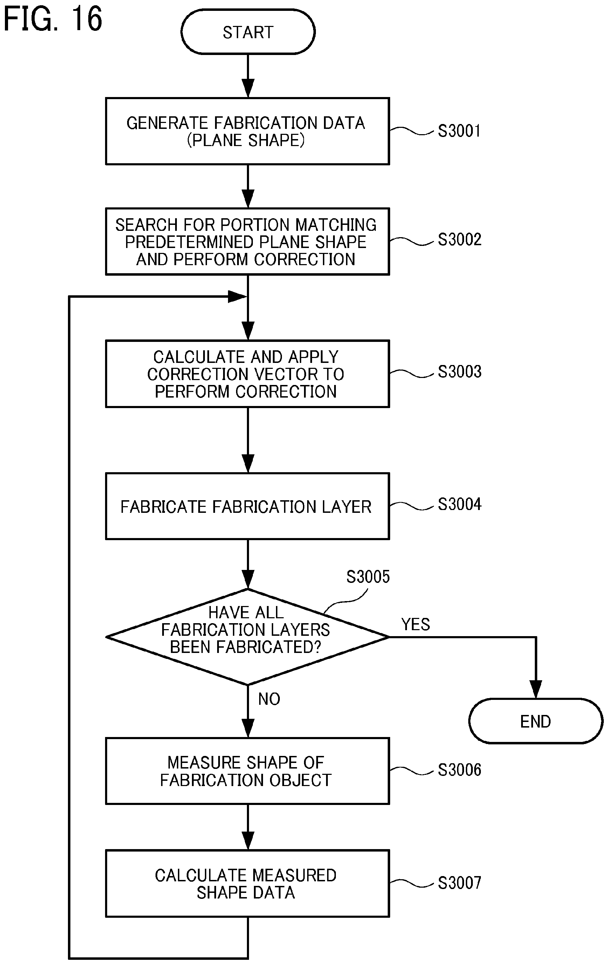

Details of the shape to be fabricated, the dummy fabrication, and the main fabrication are described below. FIGS. 14A to 14G are illustrations of deformation of the shape of the fabrication object, feedforward correction, and modification of the feedforward correction in the present embodiment. FIG. 15 is a flowchart of the dummy fabrication in the present embodiment. FIG. 16 is a flowchart of the main fabrication in the present embodiment. FIGS. 15 and 16 are also described below with reference to FIG. 14 as appropriate.

For example, a case is described where the desired shape is a shape having a corner of 90 degrees on the xy plane as illustrated in FIG. 14A. When fabrication is performed based on the fabrication data, a fabrication object having the shape illustrated in FIG. 14B is fabricated under the surface tension and viscosity of the fabricating material. In other words, the corner is not fabricated at 90 degrees indicated in the fabrication data and has a rounded shape. The correction unit 360 corrects a shape as illustrated in FIG. 14A in advance so that a shape as illustrated in FIG. 14C is obtained. As a result, the actually-fabricated object has a shape as illustrated in FIG. 14D, and a shape close to the shape of the desired fabrication data (FIG. 14A) can be formed.

As illustrated in FIG. 15, the fabricating apparatus 100 starts the dummy fabrication. In step S2001, the fabricating device 206 fabricates a dummy fabrication object having a predetermined shape. Here, as an example, it is assumed that a predetermined correction is performed in advance based on the fabrication data including the 90-degree angle illustrated in FIG. 14A, and the fabrication object in FIG. 14C is fabricated.

In step S2002, the object shape measuring unit 340 measures the shape of the fabricated dummy fabrication object. Here, it is assumed that the dummy fabrication object has been fabricated in a shape as illustrated in FIG. 14E and measured. That is, it is assumed that the corner is fabricated so as to project from the shape of the corner illustrated in FIG. 14A. FIG. 14F is an enlarged view of a region indicated by a broken line in FIG. 14E. In FIG. 14F, displacement vectors are indicated by arrows.

In step S2003, the measured shape data generating unit 350 calculates measured shape data (difference data) from the fabrication data having been used as the basis of fabrication, based on the measured shape data of the dummy fabrication object (the example illustrated in FIG. 14F).

In step S2004, the correction unit 360 calculates correction vectors based on the measured shape data (difference data) in the same manner as the manner illustrated in FIGS. 9A to 9E (the example illustrated in FIG. 14G). Thereafter, the correction unit 360 performs correction using the modified correction vectors. In step S2004, the correction vectors may be newly calculated, or the correction vectors having been set in advance may be modified. The modified correction vectors may be applied to fabricate the same shape again, and the modification and re-fabrication may be repeated until the desired shape is obtained. The correction vectors modified in step S2004 can be stored in the storage unit 370. As a result, for example, the fabrication data of FIG. 14A, which is originally supposed to be corrected as illustrated in FIG. 14C in the correction unit 360, is modified to be corrected as illustrated in FIG. 14G.

When correction vectors are calculated with a dummy fabrication object, the correction vector may be calculated based on a plurality of dummy fabrication objects to enhance the accuracy of correction. In such a case, in step S2005, the process branches depending on whether all of the plurality of dummy fabrication objects have been fabricated and the correction vectors have been calculated.

When all of the plurality of dummy fabrication objects have been fabricated and the correction vectors have been calculated (YES in step S2005), the process proceeds to terminate the dummy fabrication. When fabrication of all of the plurality of dummy fabrication objects and calculation of the correction vectors are not completed (NO in step S2005), the process returns to step S2001, and the processing of steps S2001 to S2004 is repeated for other dummy fabrication objects to be fabricated.

Thus, fabricating the dummy fabrication object(s) and calculating correction vectors can enhance the fabricating accuracy of the fabrication object. For example, when the fabrication data that is the basis of the dummy fabrication object has a shape as illustrated in FIG. 14A and is supposed to be corrected in advance to the shape as illustrated in FIG. 14C, it can be found from the dummy fabrication that the fabrication data would be actually corrected to the shape illustrated in FIG. 14E. In such a case, the corrected shape can be modified to the shape illustrated in FIG. 14G instead of the shape illustrated in FIG. 14C. Thus, the shrinkage of the corner of the fabrication object can be coped with, and the three-dimensional fabrication object can be fabricated with the desired shape.

Calculating the correction vectors by the dummy fabrication can enhance the fabricating accuracy in the main fabrication performed thereafter. As illustrated in FIG. 16, the fabricating apparatus 100 starts the main fabrication.

In step S3001, the fabrication data generating unit 320 generates planar fabrication data as slice data obtained by dividing the three-dimensional shape data input to the data input unit 310 for each layer. Here, as an example, it is assumed that the desired shape is the shape illustrated in FIG. 14A and fabrication data for fabricating the shape illustrated in FIG. 14A is generated in step S3001.

In step S3002, the correction unit 360 applies the measured shape data corresponding to the plane shape of the fabrication data to correct the fabrication data. First, a part matching the predetermined shape in the fabrication data is searched. For example, assume a case where there is a part matching the shape of FIG. 14A in the fabrication data. Correction vectors are determined in advance for the predetermined shape and applied to the part matching the predetermined shape to correct the fabrication data. When the dummy fabrication is performed and the predetermined correction vectors are modified, the modified correction vectors are applied to correct the fabrication data. That is, when the fabrication data is corrected to the fabrication data of FIG. 14C, fabrication errors and deformation due to shrinkage are taken into consideration. Accordingly, there is a high probability that a three-dimensional fabrication object having the shape illustrated in FIG. 14D can be fabricated. Therefore, in step S3002, the fabrication data is corrected by correction vectors of the applicable shape. In other words, deformation dependent on shape data is corrected by feedforward control. Note that the correction vectors to be applied are not necessarily for the same shape. For example, the fabrication data may be corrected with correction vectors for a similar shape.

In step S3003, the correction unit 360 applies measured shape data (difference data) calculated based on the fabrication data (plane shape) of the previous layer and the measurement data of the fabrication result (plane shape) as necessary, to correct the fabrication data. That is, the plane shape is corrected by feedback control. For example, the correction vectors are calculated according to the procedure illustrated in FIGS. 9A to 9E and FIG. 10.

In step S3004, the fabricating-device control unit 330 controls the fabricating device 206 based on the corrected fabrication data to fabricate fabrication layers. Thereafter, in step S3005, the process branches depending on whether all the fabrication layers have been fabricated. When all the fabrication layers have been fabricated (YES in step S3005), the fabricating-device control unit 330 determines that the three-dimensional fabrication object has been completed and thus the process proceeds to terminate the main fabrication. When all the fabrication layers are not fabricated (NO in step S3005), the process proceeds to step S3006 to fabricate the next layer.

In step S3006, to correct the next fabrication layer, the plane shape of the fabrication object is measured. The fabrication layer fabricated in step S3004 is based on the corrected fabrication data and therefore is fabricated in a desired shape. However, the shape of the fabrication object is variable depending on various conditions. Even if the fabrication data is corrected, deformation from the desired shape may still occur. For example, even if the fabrication data is corrected to the shape illustrated in FIG. 14C, an excessive correction amount may cause the projected shape of the corrected portion as illustrated in FIG. 14E Hence, in step S3006 and thereafter, as illustrated in FIG. 10, the fabrication data of the next layer (the (n + 1th) layer) and thereafter is corrected based on the measured shape data (difference data) based on the measurement data of the fabricated layer (nth layer) and fabricated based on the corrected fabrication data.

In step S3006, the object shape measuring unit 340 measures the shape of the fabrication object and outputs measurement data to the measured shape data generating unit 350. In step S3007, the measured shape data generating unit 350 calculates measured shape data based on the measurement data obtained by the object shape measurement unit 340.

After step S3007, the process returns to step S3003 and each processing described above is repeated until all the fabrication layers are fabricated. Thus, the three-dimensional fabrication object having the desired shape can be fabricated.

As described above, the shape of the dummy fabrication object may be an arbitrary shape. The dummy fabrication object may be corners of various angles. The correction vectors may be determined in advance in various plane shapes and the correction vectors may be modified by dummy fabrication. Thus, portions to which optimum correction vectors can be applied from the beginning even in an arbitrary shape, thus enhancing the fabricating accuracy.

In the above-described embodiment, the measured shape data generating unit 350 processes the measurement data measured by the object shape measuring unit 340 to calculate difference data. Here, the measurement data is data indicating an outer shape expressed as a set of edges of a fabrication object and thereby indicates the shape of the fabrication object. Therefore, accurate measurement of the edges of the fabrication object is needed to perform appropriate correction.

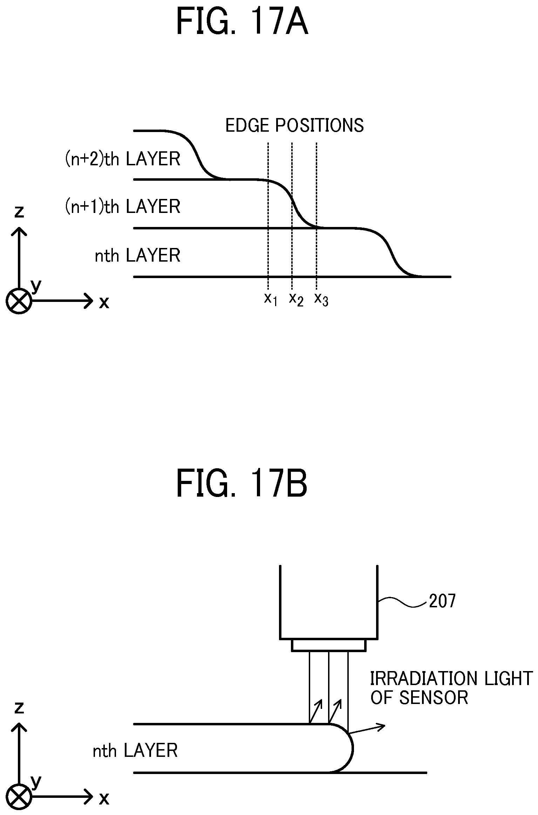

FIGS. 17A to 17D are illustrations of an edge (hereinafter referred to as "detected edge") detected by the shape sensor 207. FIG. 17A is a cross-sectional view of a three-dimensional fabrication object fabricated. Here, assume a case where the shape sensor 207 detects an edge of the (n + 1)th fabrication layer. Since the edge of the fabrication layer is detected by the shape sensor 207, the shape of the fabrication layer measured can be changed depending on which position of the fabrication layer is defined as the edge. For example, as illustrated in FIG. 17A, the shape of the fabrication layer represented by the measurement data changes depending on which of the edge positions x1, x2, and x3 is selected. If the edge position defined by one fabrication layer is not applied to another fabrication layer, accurate measurement data cannot be obtained, which affects subsequent correction processing.

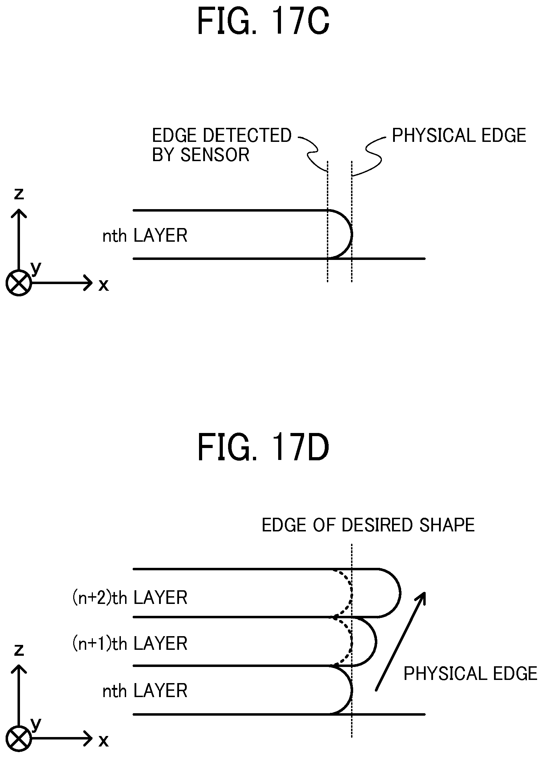

For example, when the shape sensor 207 includes an infrared light source and an infrared sensor, as illustrated in FIG. 17B, the infrared light from the infrared light source is reflected on a fabrication layer and the shape sensor 207 detects the reflected light to detect the edge of the fabrication layer. On the other hand, as illustrated in FIG. 17B, when the cross-sectional shape of a portion near the edge of the fabrication layer is rounded, the light irradiated to the rounded portion is reflected in various directions. The shape to be detected depends on the shape detection algorithm of the infrared sensor. Therefore, as illustrated in FIG. 17C, the position of the detected edge may be different from the position of the physical edge. Such a difference between the position of the detected edge and the position of the physical edge may result in a measurement error and affect the correction process.

If the correction is affected by the measurement error, the three-dimensional fabrication object is not fabricated in the desired shape. For example, in the case where the edge of the desired three-dimensional fabrication object has a shape as indicated by broken lines in FIG. 17D, even if the nth fabrication layer is fabricated in the desired shape, as illustrated in FIG. 17C, the detected edge is detected inside the physical edge. In other words, the nth fabrication layer is determined to have been fabricated smaller and the fabrication data is corrected so that the (n + 1)th fabrication layer has a larger shape. Accordingly, the physical edge of the (n + 1)th fabrication layer is positioned outside the edge of the desired shape. Similarly, each time a fabrication layer is stacked, the fabrication layer is affected by the fabrication error of the lower layer, thus hampering a desired three-dimensional fabrication object from being fabricated. In the above description, the sensor including the infrared light source and the infrared sensor is described as an example. However, the same applies even if the shape sensor 207 is formed of components other than the infrared light source and the infrared sensor.

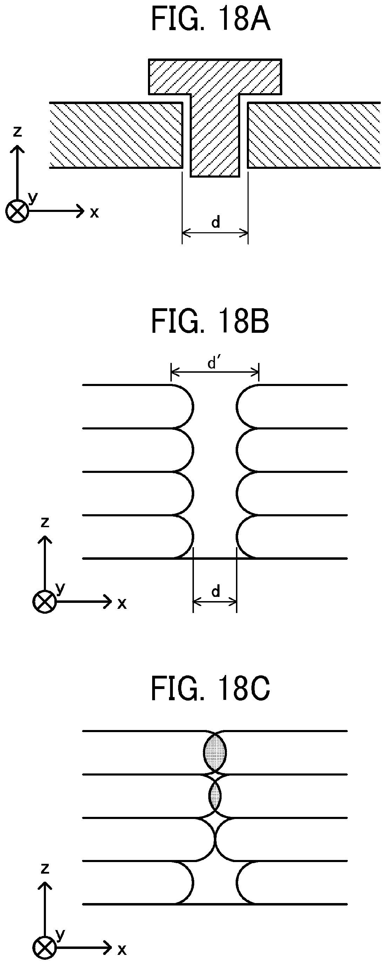

In FIG. 17, the measurement error due to the difference between the position of the detected edge and the position of the physical edge has been described. If such an error occurs, the function of the three-dimensional fabrication object fabricated is also impaired. FIGS. 18A to 18C are illustrations of examples of a fabrication layer corrected based on the detected edge. FIG. 18A is a cross-sectional view of a three-dimensional fabrication object to be fabricated and illustrates, as an example, a structure in which a hole of a dimension d is formed and an object can be fitted into the hole. In the case of such a structure, when the hole is fabricated larger, the object to be inserted easily falls off. On the other hand, if the hole is fabricated smaller, the object cannot be inserted into the hole Therefore, it is necessary to accurately fabricate the size of the hole based on the physical edge as a reference.

However, as described with reference to FIGS. 17A to 17D, measurement errors might occur in the measurement of the edge with the shape sensor 207. Accordingly, as illustrated in FIG. 18B, even when the hole of the dimension d is fabricated based on the physical edge, the dimension of the hole measured by the shape sensor 207 may be a different dimension d'. As a result, the shape of the fabrication layer constituting the hole is corrected under the influence of the shape error, and as illustrated in FIG. 18C, the hole is closed in upper layers, thus hampering insertion of the object.

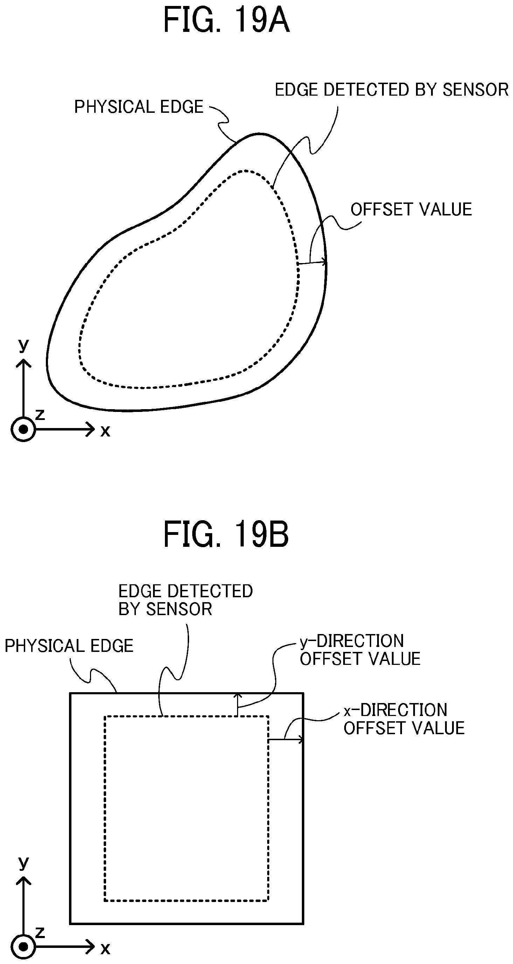

Hence, correcting the position of the detected edge with a predetermined offset value allows measurement data based on the physical edge to be output, thus allowing appropriate correction. FIGS. 19A and 19B are illustrations of correction of measurement data based on offset values in the present embodiment and are cross-sectional views of three-dimensional fabrication objects. In FIGS. 19A and 19B, the solid line indicates the physical edge of the three-dimensional fabrication object, and the broken line indicates the detected edge.

For example, when a three-dimensional fabrication object having a shape as illustrated in FIG. 19A is fabricated, the shape of the detected edge is output as measurement data. The physical edge of the three-dimensional fabrication object is obtained by correcting the measurement data with predetermined offset values. Functional units to calculate the offset values and the physical edge are not limited to any particular units or means but may be performed by, for example, the object shape measuring unit 340 or the measured shape data generating unit 350, or by cooperation of the foregoing units. Based on the shape of the physical edge obtained here, the measured shape data generating unit 350 calculates the difference data. Thus, the correction unit 360 can appropriately correct the fabrication data, thus allowing a desired three-dimensional fabrication object to be fabricated.

Further, depending on the method, arrangement, scanning direction, and the like of the shape sensor 207, as illustrated in FIG. 19B, the difference between the physical edge and the detected edge of the three-dimensional fabrication object may be measured to be different between the x axis direction and the y axis. In such a case, setting different offset values in the x-axis direction and the y-axis direction and correcting the measurement data in each direction allows the physical edge of the three-dimensional fabrication object to be obtained.

The offset values for correcting the measurement data can be calculated by, for example, fabricating a fabrication object having a groove and detecting how the groove is formed. The offset values can also be calculated by fabricating a dummy fabrication object. Note that the timing for calculating the offset values is not particularly limited. For example, the offset values may be calculated by performing dummy fabrication before main fabrication, may be calculated when a certain period of time has elapsed during main fabrication, or may be calculated when various environmental conditions, such as the fabrication material, ambient temperature, and ambient brightness change. Thus, appropriately calculating the offset value allows accurate correction of the detected edge and fabrication of a desired three-dimensional fabrication object.

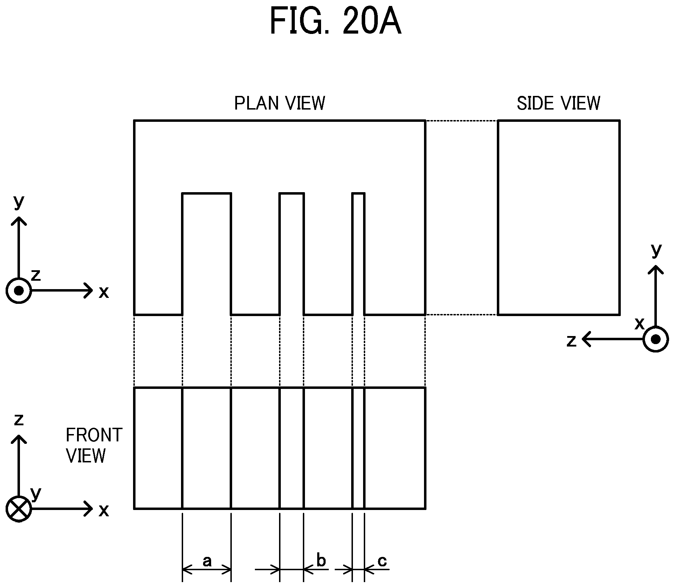

FIGS. 20A to 20D are illustrations of examples of the shape of a dummy fabrication object for calculating offset values in the present embodiment. FIG. 20A illustrates an example of the shape of the dummy fabrication object fabricated in the present embodiment and includes a plan view, a side view, and a front view of the dummy fabrication object. The dummy fabrication object of this embodiment has grooves having dimensions a, b, and c. Here, the dimension of each groove indicates a dimension based on the physical edge. In the example of FIG. 20A, the dimensions of the grooves satisfy the relation of a > b > c. In the following description, the groove having the dimension a is referred to as "groove A", and similarly, the groove having the dimension b is referred to as "groove B" and the groove having the dimension c is referred to as "groove C". The dummy fabrication object illustrated in FIG. 20A is an example, and the dummy fabrication object is not limited to the dummy fabrication object according to the present embodiment. Therefore, the dummy fabrication object may have a shape other than the shape illustrated in FIG. 20A, and the number of grooves is not limited to any particular number.

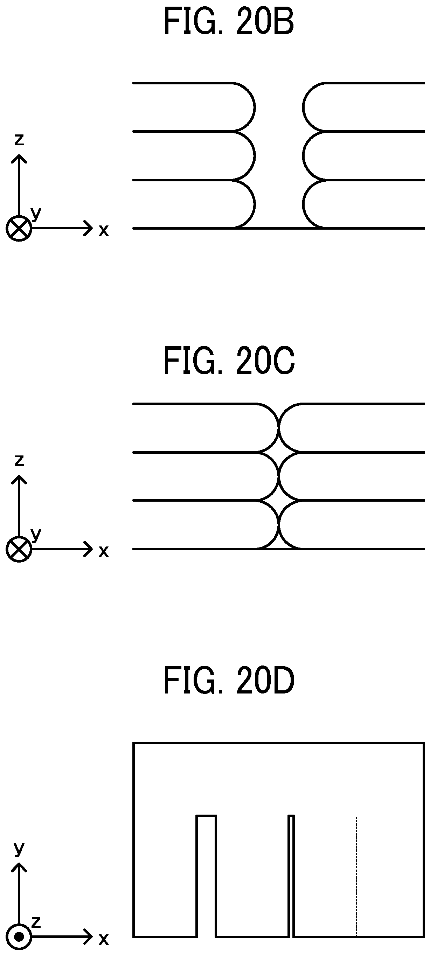

FIG. 20B is an enlarged cross-sectional view of the groove of the dummy fabrication object. When the grooves of the dummy fabrication object to be fabricated are measured by the shape sensor 207, it is desirable that each groove has a predetermined dimension (for example, a, b, or c). However, when the dummy fabrication is performed, the dummy fabrication object may not be fabricated in a desired shape due to a fabrication error or the like. For example, as illustrated in FIG. 20C, a case where the groove is closed may occur.

Hence, the fabricating apparatus 100 of the present embodiment fabricates a dummy fabrication object having grooves of various dimensions, measures the shape of the dummy fabrication object, and estimates offset values of the measurement data based on the dimensions where the grooves are closed and the dimensions where the grooves are not closed. For example, assume a case where fabrication is performed based on the shape data of the dummy fabrication object illustrated in FIG. 20A. Here, there are the following three types of dimensions. The three types are: a dimension used to instruct the fabricating apparatus 100 to fabricate; a dimension that can be measured from the position of the physical edge of an actually fabrication object; and a dimension that the object shape measuring unit 340 detects.

Due to the fabrication error, as illustrated in FIG. 20D, the dummy fabrication object may be fabricated with the groove being smaller than a predetermined dimension. FIG. 20D depicts a case where each of the grooves of the dummy fabrication object is fabricated smaller than a predetermined dimension, and in particular, the groove C having the smallest size is closed. In such a case, the offset values for correcting the measurement data can be estimated based on the predetermined dimension c of the closed groove C and the smallest dimension b of the grooves not closed.

For example, assume that a dummy fabrication object in which the dimension b of the groove B is 4 mm and the dimension c of the groove C is 3 mm is fabricated and the dummy fabrication object having the shape illustrated in FIG. 20D is fabricated. As a result, assume that the object shape measuring unit 340 detects that the groove B is not closed and has a dimension b' of 3.8 mm and detects that the groove C is closed. Although the fabricating apparatus 100 is instructed to fabricate the groove B having the dimension b of 4 mm, the measurement result of the object shape measuring unit 340 indicates that the dimension b' is 3.8 mm. For the groove C, if the fabrication of the dimension c of 3 mm is instructed, the measurement result of the object shape measuring unit 340 can be expected to be the dimension c' of 2.8 mm. However, assume that the groove is actually detected to be closed. This is due to the difference between the position of the detected edge and the position of the physical edge.

In such a case, the offset value for correcting the measurement data to a shape based on the physical edge can be estimated to be from a half value (1.9 mm) of b' to a half value (1.4 mm) of c'. Here, the half value of each dimension is obtained to consider offsets on both sides of the groove.

Therefore, the offset value can be estimated to be from 1.4 mm to 1.9 mm. This is because, if the offset value is smaller than 1.4 mm, the groove C should be detected as a groove. If the offset value is larger than 1.9 mm, the groove B should be closed and cannot be detected. That is, the offset value can be estimated to be from 1.4 mm to 1.9 mm. Correcting the detected edge with the offset value allows the measurement data to be obtained for the shape based on the physical edge.

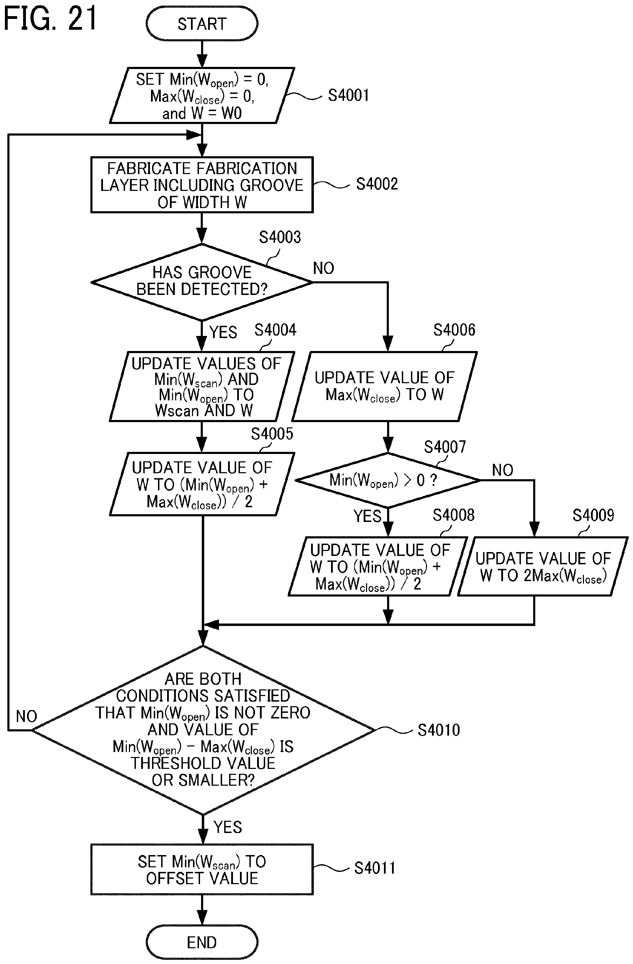

In FIGS. 20A to 20D, the example is illustrated in which the offset value is calculated with the dummy fabrication object having the grooves of various dimensions. However, the method of obtaining the offset value is not limited to the above-described example. For example, a more accurate offset value can be calculated by repeating dummy fabrication while changing the dimensions of grooves. FIG. 21 is a flowchart of a process of calculating the offset value in the present embodiment.

The fabricating apparatus 100 can calculate the offset value by performing the process illustrated in FIG. 21 in the dummy fabrication in step S1001 of FIG. 13. The fabricating apparatus 100 starts the process of calculating the offset value with step S1001 as a trigger. In step S4001, as initial values, the minimum groove dimension command width Min(Wₒₚₑₙ) is set to 0 where the groove is not closed, the maximum groove dimension command width Max(W_{close}) where the groove is closed is set to 0, and the groove dimension command value W to be fabricated is set to W0. The initial value W0 can be an arbitrary value.

In step S4002, the fabricating-device control unit 330 controls the fabricating device 206 to fabricate a dummy fabrication object having a groove having a width dimension of W Note that the dummy fabrication object fabricated in step S4002 may be a single fabrication layer.

In step S4003, the object shape measuring unit 340 measures the shape of the dummy fabrication object fabricated in step S4002. In step S4003, the process branches depending on whether the groove is detected. If the groove is detected (YES in step S4003), the process proceeds to step S4004. If no groove is detected (NO in step S4003), the process proceeds to step S4006.

First, the case is described where the groove is detected in step S4003. In such a case, the offset value cannot be calculated only by detecting the groove. To calculate a more accurate offset value, it is preferable to further narrow the value of W and perform dummy fabrication of the groove again.

In step S4004, assume that the detected value of the groove width is, for example, W_{scan}. The minimum groove dimension detection value Min(W_{scan}) where the groove is not closed is updated to W_{scan} and the minimum groove dimension command width Min(Wₒₚₑₙ) where the groove is not closed is updated to W. In step S4005, the value of W is updated as (Min(Wₒₚₑₙ) + Max(W_{close})) / 2. Updating the value of W as described above allows the groove to be fabricated with a narrower width. After updating the value of W in step S4005, the process proceeds to step S4010.

Next, a case where no groove is detected in step S4003 is described. In such a case, it is preferable to increase the width W of the groove and perform dummy fabrication of the groove again. In step S4006, the value of Max(W_{close}) is updated to W. Thereafter, in step S4007, the process branches depending on whether the value of Min(Wₒₚₑₙ) is greater than 0 (whether Min(Wₒₚₑₙ) is not the initial value). If the value of Min(Wₒₚₑₙ) is greater than 0 (YES, that is, not the initial value), the process proceeds to step S4008. In step S4008, the value of W is updated as (Min(Wₒₚₑₙ) + Max(W_{close})) / 2. After updating the value of W in step S4008, the process proceeds to step S4010.

In step S4006, when the value of Min(Wₒₚₑₙ) is 0 or less (NO, that is, still remains the initial value), the process proceeds to step S4009. In step S4009, the value of W is updated as 2Max(W_{close}). After updating the value of W in step S4009, the process proceeds to step S4010.

After updating the value of W in step S4005, S4008, or S4009, the processing of step S4010 is performed. In step S4010, the process branches depending on whether the value of Min(Wₒₚₑₙ) is not 0 (condition 1) and the value of (Min(Wₒₚₑₙ) - Max(W_{close})) is less than or equal to a threshold value (condition 2). Condition 1 is a condition for guaranteeing that each of the fabrication in which the groove is not closed and the fabrication in which the groove is closed is performed at least once. Regarding Condition 2, a practical offset value can be obtained if the difference between the minimum groove dimension command value at which the groove is not closed and the maximum groove dimension command value at which the groove is closed is sufficiently small. Therefore, condition 2 is a condition for preventing further loop processing from being performed. If the conditions of step S4010 are not satisfied (NO), the process returns to step S4002, and each processing described above is repeated until the conditions are satisfied. If the conditions of step S4010 are satisfied (YES), the process proceeds to step S4011.

In step S4011, the value of Min(W_{scan}) is set as the offset value. Then, the fabricating apparatus 100 ends the process of calculating the offset value with the dummy fabrication.

According to the process of FIG. 21 described above, the calculation of the offset value can be repeated until the offset value converges within the allowable range, thus allowing the measurement data at the detected edge to be modified with a more accurate offset value.

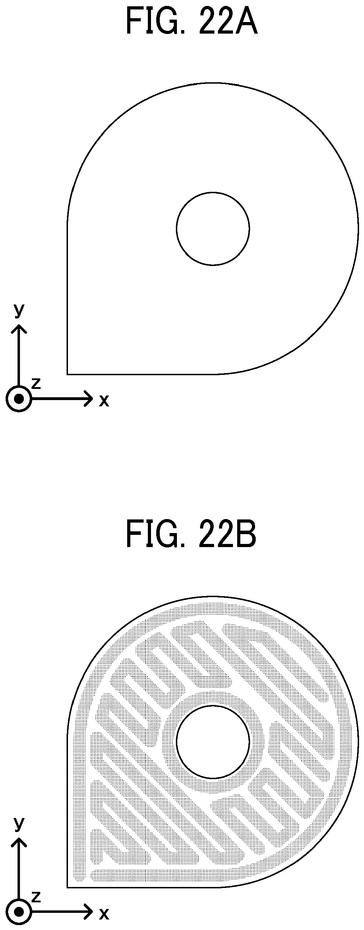

In FIGS. 20A to 20D and FIG. 21, the offset value is obtained based on the dummy fabrication. However, in some embodiments, the offset value may be calculated during the main fabrication. FIGS. 22A and 22B are illustrations of an example in which an offset value is calculated during the main fabrication.

When fabricating a three-dimensional fabrication object having the shape illustrated in FIG. 22A, the fabrication data generating unit 320 generates plane-shaped fabrication data as slice data obtained by dividing the input three-dimensional data for each layer. The fabrication data generating unit 320 also generates tool paths. FIG. 22B depicts an example of the tool paths. After fabricating the contour of a fabrication layer, the inside of the fabrication layer is fabricated so as to fill the contour. The inside of the fabrication layer is fabricated in parallel with a predetermined angle as illustrated in FIG. 22B. In general, when the interval between parallel tool paths is narrow, the internal filling rate increases and the strength of the three-dimensional fabrication object increases. In contrast, when the interval between the tool paths is wide, the amount of the fabricating material used can be reduced and the time required for fabrication can be shortened. The interval between the tool paths is designated by the user according to the purpose of fabrication.

Here, in the main fabrication, when it is allowed to partially change the interval between the parallel tool paths, the fabrication can be performed while changing the interval between the tool paths in a given part. Thus, similar to the above-described dummy fabrication object, it can be determined whether a groove is formed. In the above-described calculation of the offset value during the main fabrication, the interval between tool paths is changed for a part of the fabrication layer. Therefore, the influence on the three-dimensional fabrication object is small, and the offset value can be calculated while fabricating the three-dimensional fabrication object having the shape desired by the user.

For example, when adjacent linear fabrication objects contact each other, the interval between the tool paths is increased. Moreover, when a groove is formed between adjacent linear fabrication objects, the interval between the tool paths is narrowed. In such a way, fabricating is performed while changing the interval between the parallel tool paths, and the object shape measuring unit 340 measures the presence or absence of the groove. Thus, the threshold can be calculated between the tool path interval where the groove is generated and the tool path interval where the groove is not generated. Accordingly, the offset value can be estimated in the same manner as the calculation of the offset value by the dummy fabrication object.

In the above-described embodiment, the object shape measuring unit 340 controls the shape sensor 207 to measure the shape of the three-dimensional object to acquire measurement data. The measured shape data generating unit 350 processes the measurement data to calculate difference data. Therefore, the accuracy of the difference data, the calculation time required to calculate the difference data, and the amount of calculation resources required depend on the measurement accuracy of the measurement data. There is a plurality of types of methods for the shape sensor 207 to measure the shape. Here, taking the case of using an optical cutting type 3D scanner as an example, the measurement accuracy of the measurement data is described below.

The optical cutting type 3D scanner includes a laser light source that linearly emits laser light and an imaging device such as a camera. The 3D scanner irradiates a target object with linear laser light from the laser light source and shoots a line (bright line) drawn by the laser light on the target object with the imaging device. Based on the position of the bright line and the positional relationship between the laser light source and the camera, the depth of a portion of the object irradiated with the bright line is calculated to obtain three-dimensional information.

The depth of a linear portion hit by the bright line can be obtained from one image taken by the imaging device. To obtain the depth of the entire measurement object, shooting is continuously performed while scanning the 3D scanner, depth information is calculated, and stereoscopic data is reconstructed. Here, to measure the shape with high accuracy, it is desirable to acquire high-resolution depth information by using a camera capable of capturing a high-resolution image or by reducing the scanning speed. However, as the resolution of the depth information increases, the amount of data to be calculated increases. As a result, the calculation processing time becomes longer and more calculation resources are consumed. In addition, when the scanning speed is reduced for higher resolution, the scanning time becomes longer. That is, there is a trade-off relationship between the measurement accuracy and the time and calculation resources required. The trade-off relationship is common to measurement methods other than the exemplified 3D scanner of the optical cutting method.

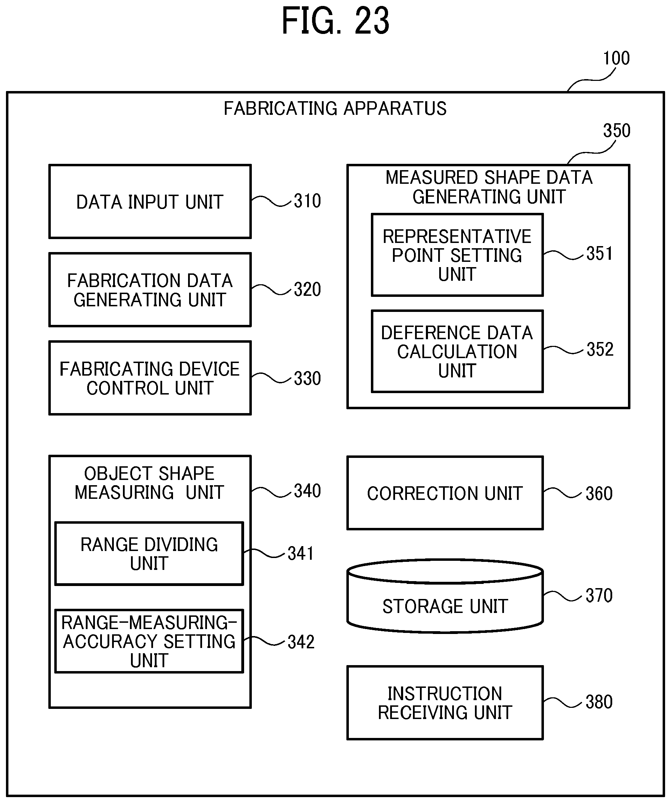

Below, with reference to FIG. 23, a description is given of another embodiment capable of dealing with the above-described trade-off between the measurement accuracy and the required time and calculation resources. FIG. 23 is a block diagram of software included in the fabricating apparatus 100 according to another embodiment of the present disclosure. Note that the software block diagram shown in FIG. 23 has portions in common with the portions illustrated in FIG. 3, and differences from FIG. 3 are mainly described below.

Similarly with the embodiment described with reference to FIG. 3, the fabricating apparatus 100 includes a data input unit 310, a fabrication data generating unit 320, a fabricating-device control unit 330, an object shape measuring unit 340, a measured shape data generating unit 350, a correction unit 360, and a storage unit 370.

The fabrication data generating unit 320 is a generating unit that generates fabrication data for each fabrication layer. In the present embodiment, the fabrication data generating unit 320 can further input the generated fabrication data to the object shape measuring unit 340.

The object shape measuring unit 340 as a measuring unit controls the shape sensor 207 and measures measurement data, such as dimensions and height, as the shape of a fabrication layer (fabrication object in the middle of fabrication) during fabrication or a three-dimensional fabrication object after fabrication. Here, the shape sensor 207 is configured to be able to switch the measurement accuracy at a plurality of levels. The measurement accuracy at the plurality of levels can be implemented, for example, by providing a plurality of values for the scanning speed of the 3D scanner. Alternatively, in combination with or instead of the scanning speed, the resolution setting (image quality setting) of the image to be acquired or stored in the imaging device constituting the shape sensor 207 may be used.

In the block diagram of software illustrated in FIG. 23, the object shape measuring unit 340 further includes a range dividing unit 341 and a range-measurement-accuracy setting unit 342.

The range dividing unit 341 divides the shape measurement range based on the fabrication data input to the object shape measuring unit 340. When a user assigns an attribute value (a value representing the complexity of the shape) to each part in the shape data in advance, the attribute value is attached to the region of each shape in the fabrication data generated based on the shape data. The range dividing unit 341 divides the entire measurement range into one or a plurality of ranges based on the attribute value assigned in advance. Even when such an attribute value is not given, the range dividing unit 341 analyzes the input fabrication data. Similarly to the process of setting the representative points to the reference shape described above, the range dividing unit 341 can divide the entire measurement range into a portion having only monotonous and low spatial frequency component and a portion having a complicated and high spatial frequency component, or can divide the entire measurement range at three or more levels of complexity. The range dividing unit 341 constitutes a dividing unit in the present embodiment.

Note that the granularity at which the measurement range can be divided also depends on the shape sensor 207. For this reason, each range is set so as to include one or a plurality of regions corresponding to a shape having a certain complexity. In such a case, if regions with high complexity and regions with low complexity are intricate and a portion having a highly complex shape is included in a range containing a region with low complexity, the highly complex shape can be prioritized.

The range-measurement-accuracy setting unit 342 for each range sets the measurement accuracy at any one of a plurality of switchable levels to the shape sensor 207 for each of the ranges divided by the range dividing unit 341. The range-measurement-accuracy setting unit 342 sets a higher measurement accuracy for a range including a more complex region and a lower measurement accuracy for a range including a more simple region. The range-measurement-accuracy setting unit 342 constitutes an accuracy setting unit in the present embodiment. The object shape measuring unit 340 switches the measurement accuracy set in the shape sensor 207 for each range and measures the measurement data.

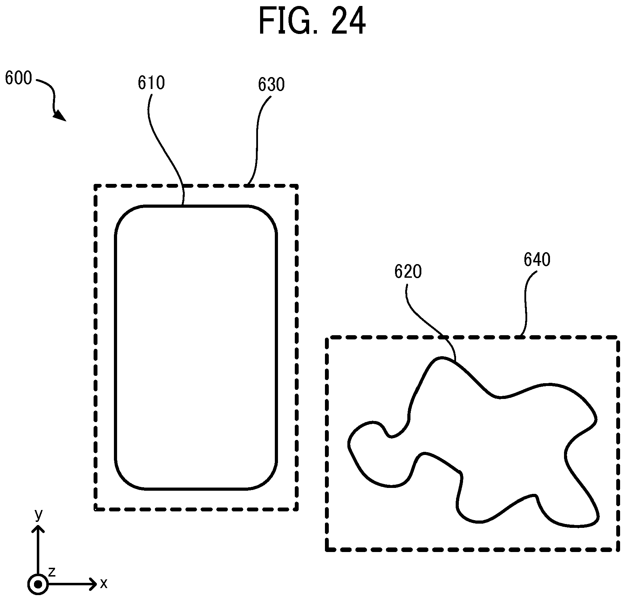

FIG. 24 depicts an example of fabrication data 600 for one layer of stacked layers. In FIG. 24, two regions, a region 610 and a region 620, are illustrated as regions constituting a fabrication object to be fabricated. The shape of the region 610 is linear and large in size and the region 620 has a relatively complex shape. In such an example, the range dividing unit 341 divides the entire measurement range into a first measurement range 630 that includes the region 610 and a second measurement range 640 that includes the region 620. The range-measurement-accuracy setting unit 342 sets the first measurement range 630 to a low accuracy and sets the second measurement range 640 to a high accuracy. As a result, the first measurement range 630 can be measured at a higher speed or can be processed in a short time and with low resources during data processing. In the second measurement range 640, the measurement is slow and it takes a long time and high resources during data processing, but highly accurate shape data is acquired.

When it is necessary to measure the shape with high accuracy, the measurement data is acquired with high resolution even at the expense of the time required for measurement. Conversely, when accuracy is not so required, measurement data is acquired at a low resolution to shorten the time required for measurement. As a result, it is possible to measure the fabrication object with necessary and sufficient accuracy while reducing the time required for measurement and the required amount of resources as a whole.

The measurement shape data generation unit 350 calculates measurement shape data (difference data) based on the measurement data measured by the object shape measuring unit 340. The correction unit 360 corrects the fabrication data based on the measured shape data (difference data) calculated by the measured shape data generating unit 350.

By the way, in the above-described embodiment, the correction unit 360 corrects and outputs the fabrication data based on the measured shape data (difference data) calculated by the measured shape data generating unit 350 so that the shape is deformed the opposite direction to the difference data. However, the fabrication amount (e.g., the discharge amount of the fabrication material 140 in the FFF method or the laser intensity and the spot diameter in the SLS method) can be corrected instead of the deformation of the shape or together with the deformation of the shape.

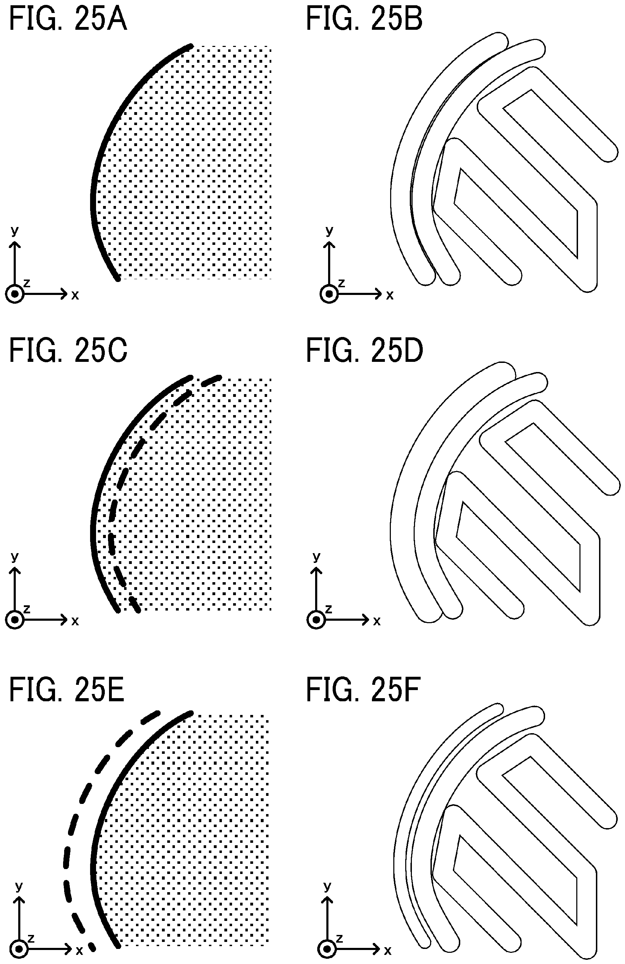

Hereinafter, a specific embodiment that corrects the above-described fabrication amount is described with reference to FIG. 3 again and FIGS. 25A to 25F.

The correction unit 360 corrects the fabrication data based on the measured shape data (difference data) calculated by the measured shape data generating unit 350 so that the fabricating operation performed by the fabricating-device control unit 330 is changed. In this specific embodiment, changing the fabrication operation includes changing the fabrication amount. The correction unit 360 calculates a correction amount for the fabrication amount based on the measured shape data (difference data) calculated by the measured shape data generating unit 350. The correction amount is calculated as a change amount from a reference fabrication amount (a default value, a reference value, or the like). The calculated correction amount is reflected in the corrected fabrication data. The correction unit 360 constitutes a correction amount calculation unit in the present embodiment.

The fabricating-device control unit 330 controls an operation of fabricating a three-dimensional fabrication object with the fabricating device 206 according to the fabrication data. The fabricating-device control unit 330 performs control to change the final fabrication amount based on the corrected fabrication data in which the correction amount for the fabrication amount is calculated by the correction unit 360. For example, in the FFF method, the fabricating-device control unit 330 performs control to change the discharge amount of the fabrication material 140. For example, in the SLS system, the fabricating-device control unit 330 performs control to change the laser intensity and the spot diameter. In the present embodiment, the fabricating-device control unit 330 constitutes a fabrication amount changing unit that changes the fabrication amount.

FIGS. 25A to 25F are illustrations of a fabrication process for calculating a correction amount of a discharge amount based on difference data and performing fabrication based on the correction amount in a specific embodiment.

Here, as an example, it is assumed that there is a shape of one layer obtained by slicing a fabrication object as illustrated in FIG. 25A. In the FFF method, for example, as illustrated in FIG. 25B, the nozzle is moved while molten resin is discharged from the nozzle according to the tool path, to stack layers of resin.

Here, as illustrated in FIG. 25C, it is assumed that a solid line represents a desired shape, and as a result of measuring the shape, an edge was at the position of a dotted line inside the shape from the solid line. That is, assume that it was found as the result of the measurement that a shape (thin shape) that was more recessed than the desired shape was fabricated. To correct the more recessed shape to form the desired shape, it is desirable to fabricate a more inflated shape (thick shape) when fabricating a similar shape in the next layer. As one example of such correction, the path for moving the nozzle can be changed. Here, as illustrated in FIG. 25D, the discharge amount of resin discharged onto the outer periphery of the shape is increased while the path for moving the nozzle is the same as the path of FIG. 25B. Thus, the desired shape (inflated shape or thick shape) can be fabricated.

Similarly, as illustrated in FIG. 25E, it is assumed that, as a result of measuring the shape, the edge was at the position of a dotted line outside the shape from the solid line. That is, assume that it was found as the result of the measurement that a shape (thick shape) that was more inflated than the desired shape was fabricated. To correct the more inflated shape to form the desired shape, it is desirable to fabricate a more recessed shape (thin shape) when fabricating a similar shape in the next layer. As one example of such correction, as illustrated in FIG. 25F, the amount of resin discharged onto the outer periphery is reduced while the path for moving the nozzle is the same as in FIG. 25B. Thus, the desired shape (recessed shape or thin shape) fan be fabricated.

Although the above description has been made here on the assumption that the discharge amount is changed without changing the path for moving the nozzle, in some embodiments, the discharge amount may be changed while changing the path for moving the nozzle.

As described above, according to the present embodiment, there can be provided a fabricating system, an information processing apparatus, an information processing apparatus, and an information processing method that can enhance the accuracy and stability of the three-dimensional shape of a fabrication object with a low calculation load.

In particular, the expression method of the measured shape according to the present embodiment can cope with, in addition to deformation considered to be caused by mechanical errors and optical errors of the fabricating apparatus, deformations over time caused by, for example, shrinkage and deformation of the material and the flow of the material before the material is solidified. Setting appropriate representative points allows the measurement shape to be expressed in such a way that high spatial frequency components are blocked as noise in a portion of the reference shape that has only monotonous and low spatial frequency components, while high spatial frequency components are maintained in another portion of the reference shape that has complex and high spatial frequency components. Such a configuration can balance the reproducibility of shape and the ease of noise removal.

Each function of each embodiment of the present disclosure described above can be realized by a device-executable program written in C, C ++, C #, Java (registered trademark) or the like. Programs to achieve each function in the each embodiment can be stored and distributed in a device-readable recording medium, such as a hard disk device, a compact disc-read only memory (CD-ROM), a magneto-optical disc (MO), a digital versatile disc (DVD), a flexible disk, an electrically erasable and programmable read only memory (EEPROM), an erasable programmable read only memory (EPROM), etc., and can be transmitted via a network in a format that other devices can use.

Although the invention has been described above with reference to the embodiments, the invention is not limited to the above-described embodiments. Within the range of embodiments that can be estimated by skilled person, those exhibiting functions and effects of the invention are included in the scope of the invention. The above-described embodiments are illustrative and do not limit the present invention. Thus, numerous additional modifications and variations are possible in light of the above teachings. For example, elements and/or features of different illustrative embodiments may be combined with each other and/or substituted for each other within the scope of the present invention. Any one of the above-described operations may be performed in various other ways, for example, in an order different from the one described above. Each of the functions of the described embodiments may be implemented by one or more processing circuits or circuitry. Processing circuitry includes a programmed processor, as a processor includes circuitry. A processing circuit also includes devices such as an application specific integrated circuit (ASIC), digital signal processor (DSP), field programmable gate array (FPGA), and conventional circuit components arranged to perform the recited functions.

The present invention can be implemented in any convenient form, for example using dedicated hardware, or a mixture of dedicated hardware and software. The present invention may be implemented as computer software implemented by one or more networked processing apparatuses. The processing apparatuses include any suitably programmed apparatuses such as a general purpose computer, personal digital assistant, mobile telephone (such as a WAP or 3G-compliant phone) and so on. Since the present invention can be implemented as software, each and every aspect of the present invention thus encompasses computer software implementable on a programmable device. The computer software can be provided to the programmable device using any conventional carrier medium (carrier means). The carrier medium includes a transient carrier medium such as an electrical, optical, microwave, acoustic or radio frequency signal carrying the computer code. An example of such a transient medium is a TCP/IP signal carrying computer code over an IP network, such as the Internet. The carrier medium may also include a storage medium for storing processor readable code such as a floppy disk, hard disk, CD ROM, magnetic tape device or solid state memory device.

## Claims

1. A fabricating system (1000) for three-dimensional fabrication, comprising:
an acquiring unit (340) configured to acquire a reference shape;
a measuring unit (340) configured to measure a shape of a fabrication object during or after fabrication, to acquire a measured shape of the fabrication object;
a setting unit (351) configured to set a plurality of representative points of the reference shape based on the reference shape; and
a calculation unit (352) configured to, based on the measured shape of the fabrication object by the measuring unit (340), calculate difference data representing a difference between the reference shape and the measured shape of the fabrication object as a deformation represented by displacements of the plurality of representative points.

2. The fabricating system according to claim 1,
wherein the measured shape of the fabrication object is a cross-sectional shape, and
wherein the calculation unit (352) compares the cross-sectional shape of the fabrication object measured by the measuring unit (340) and a cross-sectional shape of the fabrication object based on the reference shape to calculate the difference data.

3. The fabricating system according to claim 1 or 2,
wherein the difference data calculated by the calculation unit (352) is used to correct an input three-dimensional shape, and
wherein the reference shape includes the input three-dimensional shape, a corrected three-dimensional shape obtained by correcting the input three-dimensional shape, and a cross-sectional shape obtained from the input three-dimensional shape and the corrected three-dimensional shape.

4. The fabricating system according to claim 3, further comprising an instruction receiving unit (380) configured to receive an instruction of continuation or starting-over of the fabrication,
wherein the measuring unit (340) measures the shape of the fabrication object fabricated, at time points at least one of during the fabrication and after the fabrication, and
wherein the instruction receiving unit (380) receives the instruction of continuation of the fabrication based on the corrected three-dimensional shape during the fabrication or starting-over of the fabrication based on the corrected three-dimensional shape.

5. The fabricating system according to claim 3 or 4,
wherein the measuring unit (340) performs a plurality of times of measurements of the shape of the fabrication object during the fabrication,
wherein the calculation unit (352) calculates the difference data in each of the plurality of times of measurements, and
wherein a plurality of sets of difference data obtained based on the plurality of times of measurements is used to correct the input three-dimensional shape.

6. The fabricating system according to any one of claims 3 to 5, further comprising a storage unit (370) configured to store a correction result corrected based on the difference data calculated by the calculation unit (352),
wherein, when a three-dimensional shape that at least partially matches a shape stored in the storage unit (370) is fabricated under a same condition as the shape stored in the storage unit (370), a portion of the three-dimensional shape that at least partially matches the shape stored in the storage unit (370) is corrected based on the correction result stored in the storage unit (370).

7. The fabricating system according to any one of claims 3 to 6,
wherein, based on the difference data between the corrected three-dimensional shape and the shape of the fabrication object obtained by fabricating the corrected three-dimensional shape, the corrected three-dimensional shape is further corrected and a correction result held in the fabricating system is updated.

8. The fabricating system according to any one of claims 3 to 7, further comprising:
a generating unit (320) configured to divide the input three-dimensional shape with respect to a height direction into cross-sectional shapes to generate fabrication data; and
a fabricating device (206) configured to fabricate the fabrication object based on the fabrication data,
wherein the measuring unit measures the shape of the fabrication object at each of a plurality of time points during the fabrication,
wherein the calculation unit (352) calculates difference data between a cross-sectional shape divided in the height direction and a cross-sectional shape based on the shape measured at each of the plurality of time points, and
wherein the input three-dimensional shape is corrected with a plurality of sets of difference data obtained by measurements at the plurality of time points.

9. The fabricating system according to any one of claims 1 to 8, further comprising a correction unit (360) configured to correct the measured shape of the fabrication object measured by the measuring unit.

10. The fabricating system according to claim 9,
wherein a correction amount in a correction process performed by the correction unit is calculated by dummy fabrication.

11. The fabricating system according to claim 10,
wherein the dummy fabrication fabricates a fabrication object having a plurality of dimensions of grooves.

12. The fabricating system according to claim 10,
wherein the dummy fabrication is performed while changing a dimension of a groove.

13. The fabricating system according to claim 9,
wherein the correction unit calculates a correction amount during the fabricating.

14. The fabricating system according to any one of claims 10 to 13,
wherein the correction unit calculates a correction amount when a condition of a surrounding environment changes.

15. A method for expressing a shape of a fabrication object with a computer, the method comprising:
acquiring (S101) a reference shape;
acquiring (S101) a measured shape of a fabrication object during or after fabrication;
setting (S103) a plurality of representative points of the reference shape based on the reference shape; and
calculating (S105), based on the reference shape acquired and the measured shape acquired, difference data representing a difference between the reference shape and the measured shape of the fabrication object, as a deformation represented by displacements of the plurality of representative points.
